(19) Europäisches Patentamt
European Patent Office
Office européen des brevets

(11) **EP 3 211 791 B1**

(12) **EUROPÄISCHE PATENTSCHRIFT**

(45) Veröffentlichungstag und Bekanntmachung des Hinweises auf die Patenterteilung:
**30.10.2024 Patentblatt 2024/44**

(21) Anmeldenummer: **16000429.7**

(22) Anmeldetag: **23.02.2016**

(51) Internationale Patentklassifikation (IPC):
**H03F 1/52** *(2006.01)* **H03F 3/195** *(2006.01)*
**H03F 1/56** *(2006.01)* **H03F 3/45** *(2006.01)*
**H03F 3/72** *(2006.01)*

(52) Gemeinsame Patentklassifikation (CPC):
**H03F 1/523; H03F 1/56; H03F 3/195;**
**H03F 3/45475; H03F 3/72;** H03F 2200/108;
H03F 2200/18; H03F 2200/21; H03F 2200/216;
H03F 2200/222; H03F 2200/27; H03F 2200/294;
H03F 2200/297; H03F 2200/301; H03F 2200/312;

(Forts.)

(54) **SCHALTUNGSANORDNUNG UND VERFAHREN ZUM SCHUTZ EINES EMPFANGSMODULS**

CIRCUIT ASSEMBLY AND METHOD FOR PROTECTING A RECEIVING MODULE

CIRCUIT ET PROCEDE DE PROTECTION D'UN MODULE DE RECEPTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**30.08.2017 Patentblatt 2017/35**

(73) Patentinhaber: **HENSOLDT Sensors GmbH**
**82024 Taufkirchen (DE)**

(72) Erfinder:
• **Schmid, Ulf**
**89077 Ulm (DE)**
• **Reber, Ralf**
**89077 Ulm (DE)**

(74) Vertreter: **LifeTech IP**
**Spies & Behrndt Patentanwälte PartG mbB**
**Elsenheimerstraße 47a**
**80687 München (DE)**

(56) Entgegenhaltungen:
**EP-A1- 2 541 763      JP-A- 2002 237 728**
**JP-A- 2013 162 297      US-A1- 2008 218 271**
**US-A1- 2011 275 330**

EP 3 211 791 B1

(52) Gemeinsame Patentklassifikation (CPC): (Forts.)
H03F 2200/387; H03F 2200/411; H03F 2200/426;
H03F 2200/451; H03F 2200/462; H03F 2200/471;
H03F 2200/481; H03F 2200/519; H03F 2200/522;
H03F 2200/555; H03F 2200/75; H03F 2200/78;
H03F 2203/45528; H03F 2203/45594;
H03F 2203/45702; H03F 2203/7206;
H03F 2203/7227

**Beschreibung**

Die vorliegende Erfindung bezieht sich auf eine Schaltungsanordnung und ein Verfahren zum Schutz eines Empfangsmoduls und insbesondere auf ein Verfahren und eine Schaltungsanordnung in Sende-/Empfangsmodulen zur Verbesserung der Verträglichkeit bezüglich Empfangssignalen mit großem Leistungspegel.

Hintergrund

Ein Problem bei Empfangsmodulen besteht in einer möglichen Übersteuerung eines Verstärkers im Empfangsmodul. Solche Übersteuerungen können durch innere oder äußere Störeinflüsse ausgelöst werden, wobei die Störeinflüsse beispielsweise unerwartete Störsignale oder eine Sendetätigkeit eines mangelnd isolierten Sendemoduls umfassen können. Als Resultat können unerwünschte Signale, die außerhalb eines Eingangspegelbereiches liegen, in dem Verstärker verstärkt werden, so dass die verstärkten Ausgangssignale ebenfalls außerhalb eines vorgegebenen Parameterbereiches liegen. Im einfachsten Fall führen solche Übersteuerungen zu einer Unterbrechung der Empfangstätigkeit des Empfangsmoduls, sie können im Extremfall jedoch bis hin zur Zerstörung des Eingangsmoduls oder einer nachfolgenden Elektronik führen.

Bei den Verstärkern im Eingangsmodul kann es sich beispielsweise um rauscharme Verstärker (LNAs) in Gallium Nitrid (GaN) Technologie handeln, die zwar erfahrungsgemäß hinsichtlich irreversibler Schäden sehr robust gegen große Hochfrequenz- (HF-) Leistungspegel sind, jedoch typischerweise nach einer solchen Stressbelastung zunächst ihre DC (DC=Gleichstrom) und HF Eigenschaften verändern.

Die Erholdauer nach einer Stressbelastung, d.h. die Zeit, bis die ursprünglichen DC und HF Eigenschaften wieder hinreichend hergestellt sind, hängt stark von der Ausprägung der Stressbelastung ab. In Sende-/Empfangsmodulen (T/R-Modulen) können solche Stressbelastungen beispielsweise durch Störer verursacht werden. Bedingt durch eine begrenzte Isolation zwischen dem Sende- und dem Empfangspfad im T/R-Modul kann es wie gesagt auch im regulären Sendebetriebszustand zu einer Übersteuerung des Empfangsverstärkers kommen. Ohne geeignete Gegenmaßnahmen ist ein T/R-Modul dann für eine bestimmte Zeit nicht oder nur eingeschränkt empfangsfähig. Darüber hinaus besteht infolge der hohen Leistungsverträglichkeit und Leistungsdichte der GaN Technologie und der damit verbundenen hohen Leistungspegel am Verstärkerausgang ohne geeignete Gegenmaßnahmen für die dem Verstärker nachfolgende Niederleistungselektronik die Gefahr irreversibler Schäden bis hin zur Zerstörung.

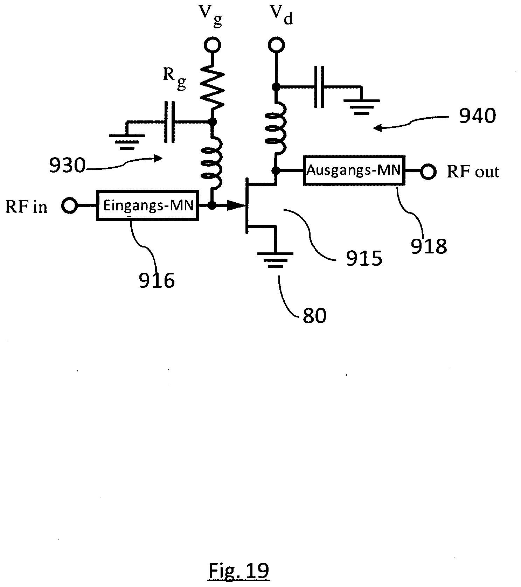

In **Fig. 19** ist ein LNA gemäß Stand der Technik vereinfacht dargestellt. Im Wesentlichen besteht dieser Verstärker aus einem oder mehreren HF-Transistoren 915 zur rauscharmen Verstärkung analoger Hochfrequenz-Signale, einem eingangsseitigen Anpassungsnetzwerk 916 (Eingangs-MN; engl.: input matching network) und einem ausgangsseitigen Anpassungsnetzwerk 918 (Ausgangs-MN engl.: output matching network). Der HF-Transistor 915 ist zwischen einer Masse 80 und einem Anschluss für eine Versorgungsspannung Vd angeordnet, wobei die Versorgungsspannung Vd beispielsweise an einem Drain-Anschluss (Drain=Transistor-Senke) als Drain-Spannung an dem Transistor 915 und die Masse 925 beispielsweise an einem Source-Anschluss (Source=Transistor-Quelle) angelegt wird.

Ferner weist der HF-Transistor 915 einen Steueranschluss (Gate) auf, der über das eingangsseitige Anpassungsnetzwerk 916 an einen Eingang (RF in) koppelt und außerdem über einen ersten Filter 930 und einen Vorwiderstand Rg an die Gate-Spannung (Steuerspannung) Vg koppelt. Der erste Filter 930 umfasst eine erste Induktivität (z.B. eine Spule), die in Reihe zwischen dem Vorwiderstand Rg und dem Steueranschluss des Transistors 915 geschaltet ist, und eine erste Kapazität (z.B. einen Kondensator), die einen Knoten zwischen dem Vorwiderstand Rg und der ersten Induktivität mit Masse 80 verbindet. Zwischen dem HF-Transistor 915 und dem Anschluss für die Versorgungsspannung Vd ist ein zweiter Filter 940 ausgebildet, der eine seriell geschaltete zweite Induktivität und eine zweite Kapazität aufweist, die den Anschluss für die Versorgungsspannung Vd mit Masse verbindet. Das ausgangsseitige Anpassungsnetzwerk 918 ist zwischen einem Ausgang (RF out) und dem beispielhaften Drain-Anschluss des Transistors 915 geschaltet.

Mit Hilfe der passiven Bauteile (dem Vorwiderstand Rg, den Induktivitäten und den Kapazitäten) werden somit dem HF-Transistor 915 Gate-seitig die Gate-Spannung Vg und Drain-seitig die Betriebsspannung Vd zugeführt. Der Vorwiderstand Rg in der Zuführung der Steuerspannung Vg dient der Begrenzung des Gate-Stroms.

Um die oben beschriebene Übersteuerung zu vermeiden, sind derzeit T/R-Module mit einem Leistungsbegrenzer (Powerlimiter) ausgestattet, der vor dem rauscharmen Verstärker (LNA) angeordnet wird (nicht in der Fig. 19 gezeigt). Dieser begrenzt die HF-Leistung, die den LNA erreicht und verhindert somit, dass sich die Eigenschaften des LNA bei einem Störszenario ändern. Der größte Nachteil ist dabei, dass der Limiter immer verlustbehaftet ist und somit auch im Normalbetrieb das Empfangssignal bedämpft. Als Folge daraus verschlechtert sich die Rauschzahl der Empfangskette.

In EP 2 541 763 wird zum Beispiel eine bekannte Schaltung offenbart, die eine Vorspannung für einen Verstärkers bereitstellt, die angepasst werden kann, um eine Abhängigkeit von der Versorgungsspannung und der Temperatur zu reduzieren. US 2011/275330 offenbart ein weiteres bekanntes System zum Schutz vor unerwartet hohen Leistungen, wobei als ein Überspannungsschutz ein Transistor über seinen Basisanschluss abgeschaltet wird. US 2008/0218271 offenbart einen weiteren Überspannungsschutz, der ebenfalls einen Transistor dadurch abschaltet, dass an dem Steueranschluss ein Potential gelegt wird, das für den Transistor unkritisch ist. Sowohl JP 2013162297 als auch JP2002237728A beziehen sich auf eine Eingangsschutzschaltung, die den Eingangtransistor eines Verstärkers vor einem übermäßigen Eingangssignal schützt.

Daher besteht ein Bedarf nach alternativen Möglichkeiten, die einen zuverlässigen Schutz vor Übersteuerungen bieten, ohne dabei den Normalbetrieb einzuschränken.

Zusammenfassung

Die oben genannte Aufgabe wird durch eine Schaltungsanordnung nach Anspruch 1 und ein Verfahren nach Anspruch 11 gelöst. Die abhängigen Ansprüche beziehen sich auf vorteilhafte Weiterbildungen der Schaltungsanordnung nach Anspruch 1.

Die vorliegende Erfindung bezieht sich auf eine Schaltungsanordnung nach dem beigefügten unabhängigen Anspruch 1, die zum Schutz eines Empfangsmoduls oder einer nachfolgenden Schaltungselektronik geeignet ist.

Im Gegensatz zum Stand der Technik werden somit während des kritischen Zustandes selbst Signale geringer Leistung nicht mehr verstärkt. Es versteht sich, dass "keine Verstärkung von Signalen" nicht notwendigerweise heißt, dass der Verstärker Eingangssignale nicht ändert, sondern lediglich, dass die übliche Verstärkung des Verstärkers (nominale Verstärkung) nicht ansatzweise erreicht wird und dass Signale am Eingang ganz oder teilweise absorbiert und/oder reflektiert werden. Beispielsweise soll ein abgeschalteter Verstärker höchstens 30% oder höchstens 10% oder nicht mehr als 1% seiner nominellen Verstärkerleistung liefern. Hiermit soll verhindert werden, dass der HF-Verstärker beeinträchtigt oder die nachfolgende Elektronik durch überhöhte Leistungspegel gestresst oder negativ beeinflusst wird.

Kritische Zustände sind beispielsweise: eine potentielle Übersteuerung des Verstärkers, ein Überschreiten eines Schwellenwertes für Signalpegel am Ausgang des Verstärkers, ein Senden von Signalen durch ein benachbartes oder ein integriertes Sendemodul oder andere Ereignisse, die das Empfangsmodul und die nachfolgende Schaltungselektronik beeinträchtigen könnten oder die das Empfangsmodul für eine (längere) Zeitdauer außer Betrieb setzen könnten. Damit sollen beispielsweise Situationen vermieden werden, von denen sich die Elektronik nur nach längeren Erholungsphasen erholen kann. Außerdem kann mit den Schwellenwerten ein normaler bzw. gewünschter Arbeitsbereich definiert werden, innerhalb dessen das Empfangsmodul und die nachfolgende Schaltungselektronik normal arbeiten können.

Die Schaltungsanordnung umfasst einen Anschluss für eine Versorgungsspannung, einen Anschluss für eine Steuerspannung und eine Masse. Der Verstärker umfasst zumindest einen Transistor (z.B. einen Feldeffekttransistor), der einen Strompfad zwischen dem Anschluss für die Versorgungsspannung und der Masse bereitstellt, wobei der Strompfad über ein Eingangssignal am Eingang und über die Steuerspannung steuerbar ist.

Die Abschalteinrichtung ist ausgebildet, um einen Stromfluss entlang des Strompfades durch den Transistor beim Abschalten zu verhindern oder zumindest deutlich zu verringern.

Die Versorgungsspannung definiert beispielsweise die Drain-Spannung des Transistors und die Steuerspannung definiert einen Spannungswert an dem Gate-Anschluss des Transistors, wobei die Steuerspannung beispielsweise den Arbeitspunkt des Transistors festlegt, so dass das zu verstärkende Signal (kleine) Variationen dieses Arbeitspunktes darstellen.

Das Steuersignal umfasst ein erstes Steuersignal und ein zweites Steuersignal und die Abschalteinrichtung einen ersten Modulator und einen zweiten Modulator. Der erste Modulator ist ausgebildet, um in Antwort auf das erste Steuersignal die Steuerspannung auf ein Nullpotential zu legen, und der zweite Modulator ist ausgebildet, um in Antwort auf das zweite Steuersignal die Versorgungsspannung auf ein Nullpotential zu legen. einen Feldeffekttransistor abschnüren), wobei das Nullpotential durch die Masse gegeben sein kann.

Die Steuerspannung ist über einen variablen Vorwiderstand steuerbar, wobei das Steuermodul ausgebildet ist, um einen Widerstandswert des variablen Vorwiderstands während des kritischen Zustandes zu verringern.

Bei weiteren Ausführungsbeispielen umfasst die Abschalteinrichtung einen Schalter zur Überbrückung des Vorwiderstands und das Steuermodul ist ausgebildet, um den Schalter bei Vorliegen des kritischen Zustandes zu aktivieren und so den Vorwiderstand zu überbrücken. Das Überbrücken des Vorwiderstandes bietet den Vorteil, dass die Spannung, die an dem Steueranschluss anliegt, beispielsweise möglichst schnell auf ein Nullpotential gelegt werden kann, um so den Verstärker möglichst schnell abzuschalten.

Bei weiteren Ausführungsbeispielen zeigt das erste Steuersignal und/oder das zweite Steuersignal einen zukünftigen kritischen Zustand an, und das Steuermodul ist ausgebildet, um das zweite Steuersignal zeitlich vor dem ersten Steuersignal auszugeben, um die Versorgungsspannung vor der Steuerspannung auf das Nullpotential zu setzen. Beispielsweise kann dazu zwischen dem zweiten Steuersignal und dem ersten Steuersignal eine Schutzzeit ausgebildet sein. Eine solche Schutzzeit dient dazu, dass selbst unter Berücksichtigung von Signallaufzeiten und von Schaltzeiten der unterschiedlichen Bauelemente in der Schaltungsanordnung sichergestellt wird, dass in dem Moment, wenn am Steueranschluss das Potential auf null gesetzt wird, entlang des Strompfades durch den Verstärker kein Spannungsabfall anliegt. Die Schutzzeiten werden somit entsprechend den ausgebildeten Bauelementen gewählt und können insofern frei gewählt werden, solange die zuvor genannte Bedingung erfüllt ist.

Bei weiteren Ausführungsbeispielen ist der zukünftige kritische Zustand ein bevorstehendes Senden eines Sendesignals und das Steuermodul ist weiter ausgebildet, um das erste Steuersignal vor einem Zeitpunkt des bevorstehenden Sendens des Sendesignals auszugeben. Hierbei kann ebenfalls eine weitere Schutzzeit vorgesehen sein, die wiederum so gewählt werden kann, dass die Spannung an dem Steueranschluss erst auf null gesetzt wird, wenn entlang des Strompfades durch den Verstärker kein Spannungsabfall vorliegt bzw. der Transistor abgeschnürt ist.

Bei weiteren Ausführungsbeispielen umfasst das Steuermodul eine erste Auslöseschaltung und/oder eine zweite Auslöseschaltung. Die erste Auslöseschaltung kann ausgebildet sein, um beim Überschreiten eines Mindeststroms entlang des Strompfades durch den Transistor das erste Steuersignal und/oder zweite Steuersignal auszugeben. Die zweite Auslöseschaltung kann ausgebildet sein, um beim Überschreiten eines weiteren Mindeststroms durch den Anschluss für die Steuerspannung des Transistors das erste Steuersignal und/oder zweite Steuersignal auszugeben. Die erste Auslöseschaltung detektiert somit den Strom entlang des Strompfades durch den Transistor und nutzt das Überschreiten eines Schwellenwertes von diesem Strom als ein Trigger-Signal für das Abschalten des Transistors. Als weitere Möglichkeit, das Abschalten des Transistors auszulösen, detektiert die zweite Auslöseschaltung den Strom durch den Anschluss für die Steuerspannung, um basierend auf diesem Strom die Abschaltung auszulösen. Es versteht sich, dass beide Auslöseschaltungen dazu genutzt werden können, um gesteuert durch das erste Steuersignal und/oder das zweite Steuersignal sowohl den Anschluss für die Versorgungsspannung als auch den Anschluss für die Steuerspannung auf ein Nullpotential zu legen. Es handelt sich somit um zwei unterschiedliche Detektionsmechanismen, die einen potentiell kritischen Zustand des Verstärkers anzeigen können.

Bei weiteren Ausführungsbeispielen umfasst die erste Auslöseschaltung zumindest ein Bauelement, über das beim Überschreiten des Mindeststroms eine Mindestspannung abfällt. Das Bauelement kann z.B. einen Transistor, einen Widerstand oder ein anderes geeignetes Bauteil umfassen, welches zur Stromdetektion geeignet ist. Dieses Überschreiten kann detektiert werden und das erste Steuersignal und/oder zweite Steuersignal liefern. Die zweite Auslöseschaltung kann ebenfalls zumindest ein Bauelement umfassen, über das beim Überschreiten des weiteren Mindeststroms eine weitere Mindestspannung abfällt. Dieses Überschreiten kann ebenfalls detektiert werden und das erste Steuersignal und/oder zweite Steuersignal liefern. Die Mindestströme werden somit in Spannungen umgewandelt, wobei die entsprechenden Mindestwerte durch Widerstände oder andere passive Bauelemente kodiert sein können und Schwellenwerte definieren.

Bei weiteren Ausführungsbeispielen umfasst die zweite Auslöseschaltung eine Verzögerungsschaltung, die ausgebildet ist, um das erste Steuersignal zeitlich verzögert nach einem Signal, das ein Überschreiten des Mindestspannungsabfalls anzeigt, auszugeben, um so den Anschluss für die Versorgungsspannung vor dem Anschluss für die Steuerspannung auf ein Nullpotential zu setzen. Die Verzögerungsschaltung dient somit der Einhaltung der Schutzzeiten, die durch eine Auswahl für die Widerstände/Kapazitäten eingestellt werden können, so dass die Versorgungsspannung vor der Steuerspannung abgeschaltet wird.

Bei weiteren Ausführungsbeispielen ist die Schaltungsanordnung ausgebildet, um ein Rücksetzsignal zu empfangen und das Steuermodul ist ausgebildet, um das Signal, das ein Überschreiten des Mindestspannungsabfalls anzeigt, bis zum Empfang des Rücksetzsignals auszugeben. Dieser Feststellmechanismus (engl. latching) soll verhindern, dass ein vorzeitiges Reaktivieren des Verstärkers ausgelöst wird. Außerdem kann dieses "Fixieren" des kritischen Zustandes dazu dienen, dass bei einem Aussenden eines Sendesignals (als potentiell kritischer Zustand) der Verstärker erst dann wieder aktiviert wird, wenn das Sendesignal bereits beendet wurde.

Bei weiteren Ausführungsbeispielen ist die erste Auslöseschaltung ausgebildet, um bei einem Unterschreiten eines Minimalstroms entlang des Strompfades das erste Steuersignal und/oder das zweite Steuersignal aufzuheben. Die zweite Auslöseschaltung kann außerdem ausgebildet sein, um bei einem Unterschreiten eines weiteren Minimalstroms durch den Anschluss für die Steuerspannung des Transistors das erste Steuersignal und/oder zweite Steuersignal aufzuheben, wobei der Minimalstrom kleiner ist als der Mindeststrom. Eine Aufhebung des ersten Steuersignals und/oder des zweiten Steuersignals bewirkt eine Rückkehr in einen normalen Betriebsmodus. Der normale Betriebsmodus kann durch ein Anlegen einer nominellen Versorgungsspannung (Drain-Spannung) und einer nominellen Steuerspannung (Gate-Spannung) gekennzeichnet sein.

Beispielsweise ist der Mindeststrom 1 mA und der Minimalstrom ist beispielsweise 0,5 mA. Die Erfindung ist jedoch nicht auf diese spezifischen Werte eingeschränkt, stattdessen sind diese Werte nahezu frei wählbar - zumindest so lange sichergestellt ist, dass weder das Empfangsmodul noch die nachfolgende Schaltungselektronik beschädigt werden (der Verstärker kann beispielsweise deutlich höhere Ströme aushalten als die nachfolgende Schaltungselektronik). Außerdem sollte der Abstand zwischen dem Mindeststrom und dem Minimalstrom so groß gewählt sein, dass ein Schwingverhalten zwischen den beiden Zuständen (normaler Betriebsmodus und kritischer Zustand) möglichst verhindert wird. Beispielsweise sollten stets vorhandene Fluktuationen (z.B. durch Rauschen) nicht zu einem Zustandswechsel führen.

Bei weiteren Ausführungsbeispielen umfasst die Schaltungsanordnung ein oder mehrere Anpassungsnetzwerke. Zum Beispiel kann sowohl auf der Eingangsseite als auch auf der Ausgangsseite ein Anpassungsnetzwerk vorhanden sein, um beispielsweise die Impedanzen anzupassen. Außerdem können (Tiefpass-) Filter vorhanden sein, die beispielsweise verhindern, dass Hochfrequenzsignale sowohl am Eingang als auch am Ausgang des Verstärkers in die entsprechende Versorgungselektronik gelangen können.

Die vorliegende Erfindung bezieht sich auch auf ein Sende-/Empfangsmodul mit einer zuvor beschriebenen Schaltungsanordnung. Außerdem bezieht sich die Erfindung auf eine Radaranlage mit einer zuvor beschriebenen Schaltungsanordnung.

Es versteht sich, dass sich die Erfindung auf beliebige Verstärker und nicht zwingend auf rauscharme Verstärker bezieht, auch wenn dies eine bevorzugte Anwendung darstellt. Daher ist der rauscharme Verstärker, auf dem häufig in der Beschreibung Bezug genommen wird, lediglich als ein mögliches Beispiel zu verstehen.

Die vorliegende Erfindung bezieht sich auch auf ein Verfahren gemäß dem Verfahrensanspruch 11 zum Schutz eines Empfangsmoduls mit einem Verstärker oder zum Schutz einer nachfolgenden Schaltungselektronik. Das Verfahren umfasst ein Verstärken eines Eingangssignals durch den Verstärker und ein Weiterleiten des verstärkten Eingangssignals an die nachfolgende Schaltungselektronik. Das Verfahren umfasst weiter ein Ausgeben eines Steuersignals, wenn ein potentiell kritischer Zustand für den Verstärker oder für das Empfangsmodul oder für die nachfolgende Schaltungselektronik auftritt oder bevorsteht. Das Verfahren umfasst außerdem ein Abschalten des Verstärkers in Antwort auf das Steuersignal, wobei der abgeschaltete Verstärker keine Verstärkung von Signalen am Eingang durchführt.

Wenn der kritische Zustand ein bevorstehendes Senden eines Sendesignals ist, kann das Verfahren ein Ausgeben des Steuersignals vor einem Zeitpunkt des bevorstehenden Sendens des Sendesignals umfassen. Wenn der kritische Zustand ein unvorhergesehenes Störsignal von einer unbekannten Quelle ist, kann das Verfahren ein Detektieren eines Überschreitens eines Mindeststromes in dem Verstärker und, in Antwort darauf, ein Erzeugen des Steuersignals umfassen.

Alle zuvor beschriebenen Funktionen der Schaltanordnung können als weitere optionale Verfahrensschritte in dem Verfahren umgesetzt sein.

Dieses Verfahren kann ebenfalls in Form von Anweisungen in Software oder auf einem Computerprogrammprodukt implementiert oder gespeichert sein, wobei die gespeicherten Anweisungen in der Lage sind, die Schritte nach dem Verfahren auszuführen, wenn das Verfahren auf einem Prozessor (z.B. in einem Steuergerät eines Empfangsmoduls oder eine Radaranlage) läuft. Daher bezieht sich die vorliegende Erfindung ebenfalls auf ein Computerprogrammprodukt mit darauf gespeichertem Software-Code (Softwareanweisungen), die ausgebildet sind, um eines der zuvor beschriebenen Verfahren auszuführen oder Funktionen bereitzustellen, wenn der Software-Code durch eine Verarbeitungseinheit ausgeführt wird. Die Verarbeitungseinheit kann jede Form von Computer oder Steuereinheit sein, die einen entsprechenden Mikroprozessor aufweist, der einen Software-Code ausführen kann.

Ausführungsbeispiele lösen die oben genannte technische Aufgabe durch einen Verstärker, der während der HF-Übersteuerung in einen Zustand versetzt wird, in dem die erhöhte HF-Leistung den Verstärker nicht mehr in seinen DC- und HF-Eigenschaften verändert.

Ausführungsbeispiele bieten die folgenden Vorteile. Ein Limiter, der bei konventionellen Systemen eine Leistung am Eingang des Verstärkers begrenzt, ist nicht notwendig. Damit verbessern sich die Rausch- und Linearitätseigenschaften des Empfangspfads. Die Schaltungsanordnung schützt den Verstärker vor Veränderung seiner DC- und HF-Eigenschaften im Fall eines erhöhten Leistungspegels des Empfangssignals. Weiterhin wird im Störfall durch die Schaltungsanordnung der Stromverbrauch des Verstärkers gesenkt, indem der Verstärker ausgeschaltet wird. Darüber hinaus wird auch der Leistungspegel am Ausgang des Verstärkers begrenzt.

Damit wird gleichzeitig verhindert, dass die Niederleistungselektronik hinter dem Verstärker gestresst oder gar zerstört wird. Die Schaltungsanordnung gemäß der Erfindung hat im typischen Empfangsbetrieb, d.h. im Empfangsfall ohne Störer, keine Auswirkung auf die DC- und HF-Eigenschaften des T/R-Moduls wie Verstärkung, Rauschzahl und Linearität.

Die Schaltungsanordnung gemäß Ausführungsbeispielen der vorliegenden Erfindung ist somit insbesondere in Radaranlagen eingesetzt, obwohl die vorliegende Erfindung darauf nicht eingeschränkt sein soll. Sie kann vielmehr auch in Kommunikationsanlagen zur Anwendung kommen, um die Empfangselektronik vor Störsignalen oder anderen HF-Übersteuerungen zu schützen.

Im Rahmen der vorliegenden Erfindung sollen sich die Begriffe "verbinden" und "schalten" insbesondere auf elektrische Verbindungen und elektrische Verschaltungen beziehen und nur in soweit einschränkend sein, dass ein Strompfad zwischen den verbundenen/geschalteten Komponenten ausgebildet werden kann (wenn entsprechende Spannungen anliegen). Eine elektrische Verbindung muss dabei nicht notwendigerweise eine direkte elektrische Verbindung umfassen. Daher ist im Rahmen der vorliegenden Erfindung unter einer elektrischen Verbindung das Ausbilden eines Strompfades zu verstehen, der einen Fluss von elektrischen Ladungsträgern zwischen den Komponenten erlaubt. Der Begriff "Koppeln" ist so auszulegen, dass es jegliche Verbindung umfasst, über die Energie transportiert werden kann (auch drahtlos).

Kurzbeschreibung der Figuren

Die Ausführungsbeispiele der vorliegenden Erfindung werden besser verstanden mit der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränkt, sondern lediglich der Erklärung und dem Verständnis dienen. Der Umfang der Erfindung wird durch den beigefügten Anspruchssatz definiert.

Fig. 1      zeigt eine Schaltungsanordnung zum Schutz eines Empfangsmoduls gemäß einem Ausführungsbeispiel der vorliegenden Erfindung.

Fig. 2      zeigt eine vereinfachte Darstellung der Schaltungsanordnung mit dynamischer Änderung der Gate-Spannung und des Gate-Vorwiderstands gemäß Ausführungsbeispielen.

Fig. 3      zeigt eine mögliche praktische Implementierung der Schaltungsanordnung gemäß der Erfindung.

Fig. 4.     zeigt eine ideale zeitliche Abfolge des Steuersignals für den Empfangspfad, einer Versorgungsspannung, einer Steuerspannung und eines HF-Sendepulses.

Fig. 5      zeigt ein Ausführungsbeispiel für den Verstärker mit Schaltungsteil zur Detektion von HF-Übersteuerungen am Eingang, nach einem Beispiel, das zum Verständnis nützlich ist, aber nicht der beanspruchten Erfindung entspricht.

Fig. 6      zeigt ein Ausführungsbeispiel für den Verstärker mit Schutzschaltung gegen HF-Übersteuerung, nach einem Beispiel, das zum Verständnis nützlich ist, aber nicht der beanspruchten Erfindung entspricht.

Fig. 7      zeigt ein Ausführungsbeispiel für eine Ansteuerschaltung zum Schutz des Verstärkers vor HF-Übersteuerung.

Fig. 8      zeigt ein Ausführungsbeispiel für einen Programmablaufplan für ein Verfahren zur Verbesserung der Verträglichkeit in Bezug auf Empfangssignale mit großem Leistungspegel.

Fig. 9.     zeigt ein Ausführungsbeispiel einer Schaltungsanordnung gemäß der Erfindung zur Detektion einer HF-Übersteuerung mittels Überwachung des Gate-Stroms und Schutz vor HF-Übersteuerung.

Fig. 10     zeigt ein Ausführungsbeispiel für einen Zeitablaufdiagramm der Kontroll- und Steuersignale aus Fig. 9.

Fig. 11     zeigt ein Prinzip eines Tests zur Ermittlung des Einflusses der Störleistung auf die HF-Eigenschaften des Empfangspfads.

Fig. 12     zeigt einen zeitlichen Verlauf der Empfangsverstärkung nach einem kurzen Störpuls mit hohem Leistungspegel, in konventionellem Betrieb und im Betrieb gemäß der Erfindung.

Fig. 13     zeigt ein Prinzip eines weiteren Tests im Radarbetrieb zur Ermittlung des Einflusses der Sendeleistung auf die HF-Eigenschaften des Empfangspfads.

Fig. 14     zeigt den Einfluss der Sendeleistung im Radarbetrieb auf die Empfangsverstärkung

Fig. 15     zeigt die Empfangsverstärkung in Abhängigkeit von einem Leistungspegel eines Störsignals für ein typisches Pulsradarszenario.

Fig. 16.    zeigt die Empfangsverstärkung wie in Fig. 15, gemessen am selben Sende-/Empfangs-Modul, jedoch im Betrieb mit dynamischer Ansteuerung der Gate-Spannung gemäß der Erfindung.

Fig. 17     zeigt die Empfangsverstärkung, einmal gemessen an einem Sende-/Empfangs-Modul mit dynamisch angesteuerter Gate-Spannung gemäß der Erfindung und einmal gemessen an einem konventionellen Sende-/Empfangs-Modul.

Fig. 18     zeigt ein Flussdiagramm für ein Verfahren gemäß der vorliegenden Erfindung.

Fig. 19     zeigt einen konventionellen rauscharmen Verstärker.

Detaillierte Beschreibung

Gemäß der Erfindung wird ein beispielhafter rauscharmer Empfangsverstärker (LNA) bei Übersteuerung in einen Zustand versetzt, bei dem die erhöhte HF-Leistung den Verstärker nicht mehr in seinen DC- und HF-Eigenschaften beeinflusst. Im Fall der GaN Technologie mit Feldeffekttransistoren ist ein zielführender Betriebszustand des LNA im Stressfall beispielsweise dadurch gegeben, dass sowohl die Betriebsspannung (Drain-Spannung, Vd) als auch die Steuerspannung (Gate-Spannung, Vg) zu null oder auf Massepotential erzwungen wird. Hierbei ist es wichtig zu verhindern, dass sich während der Stressbelastung die Gate-Source-Spannung durch Gleichrichtung der HF-Leistung selbstständig ändert.

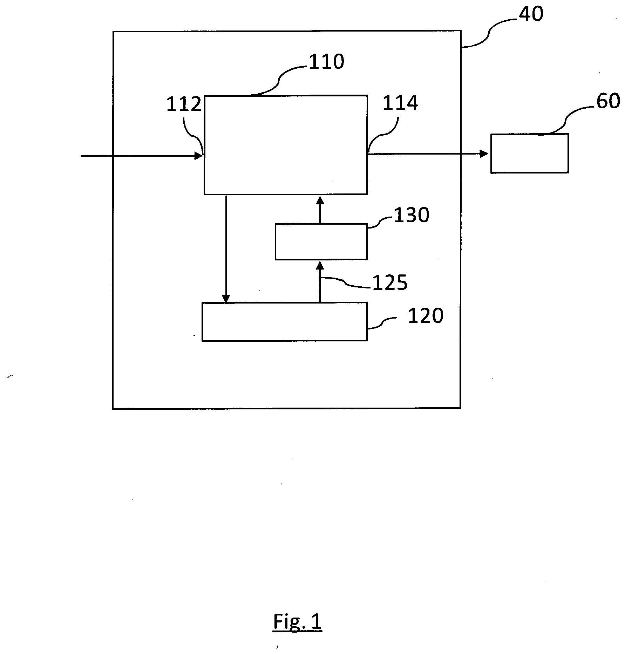

**Fig. 1** zeigt ein Ausführungsbeispiel für eine Schaltungsanordnung zum Schutz eines Empfangsmoduls 40 oder einer nachfolgenden Schaltungselektronik 60. Die Schaltungsanordnung umfasst: einen Verstärker 110 mit einem Eingang 112 und einem Ausgang 114, der mit der nachfolgenden Schaltungselektronik 60 koppelbar ist, ein Steuermodul 120, das ausgebildet ist, um bei einem potentiell kritischen Zustand für den Verstärker 110 oder für das Empfangsmodul 40 oder für die nachfolgende Schaltungselektronik 60 ein Steuersignal 125 auszugeben, und eine Abschalteinrichtung 130, die ausgebildet ist, um den Verstärker 110 in Antwort auf das Steuersignal 125 abzuschalten, wobei der abgeschaltete Verstärker 110 keine Verstärkung von Signalen am Eingang 112 durchführt.

Ohne dass die Erfindung darauf beschränkt sein soll, kann der Verstärker 110 ein rauscharmer Verstärker (LNA) basierend beispielsweise auf der GaN Technologie sein und einen oder mehrere Feldeffekttransistoren aufweisen. In diesem Fall ist ein zielführender Betriebszustand des Verstärkers 110 im Stressfall (kritischer Zustand) beispielsweise dadurch gegeben, dass sowohl die Betriebsspannung (Drain-Spannung) als auch die Steuerspannung (Gate-Spannung) durch eine Kontrollschaltung (Abschalteinrichtung) zwangsweise zu null gesetzt wird. Im Sinne der Erfindung sind jedoch auch andere Betriebszustände denkbar. In diesem Betriebszustand wirkt der Verstärker darüber hinaus als Leistungsbegrenzer, so dass auch für die nachfolgende Niederleistungselektronik keine Gefahr der Übersteuerung besteht

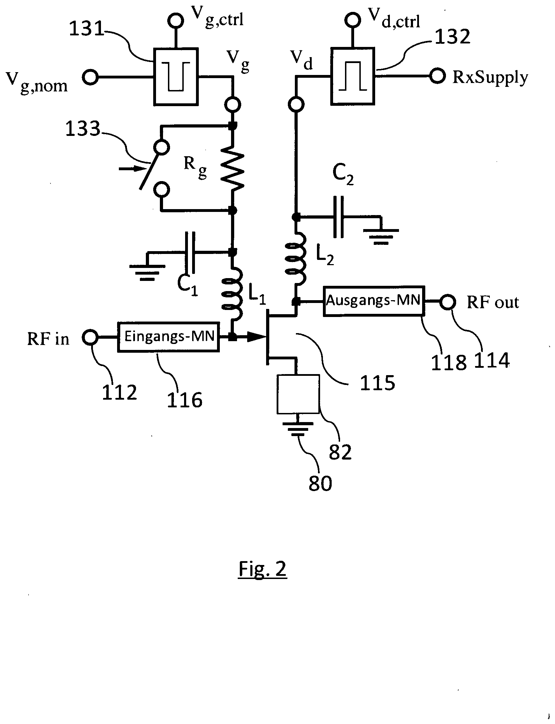

**Fig. 2** zeigt ein Ausführungsbeispiel für eine Umsetzung der Abschaltung in einer vereinfachten Darstellung der Schaltungsanordnung mit dynamischer Änderung einer Gate-Spannung Vg und eines Gate-Vorwiderstands Rg. Die Schaltungsanordnung umfasst einen Transistor 115, ein eingangsseitiges Anpassungsnetzwerk 116, ein ausgangsseitiges Anpassungsnetzwerk 118, ein optionales Source-Netzwerk 82, eine erste Kapazität C1, eine erste Induktivität L1, eine zweite Kapazität C2, eine zweite Induktivität L2, wobei die genannten Komponenten an Masse 80, einen Eingang 112 und einen Ausgang 114 koppeln. Diese Komponenten sind in der gleichen Weise verschaltet, wie in der Schaltung aus der Fig. 19, so dass eine wiederholte Beschreibung nicht notwendig ist. Das optionale Source-Netzwerk 82 dient der Bereitstellung eines von dem Massepotential abweichenden Vor-Spannungswertes (self-bias) am Source-Anschluss des Transistors 115 und/oder kann darüber hinaus beim LNA-Design in Form einer Sourcegegenkopplung zur Beeinflussung des Frequenzganges dienen.

Zusätzlich ist in dem Ausführungsbeispiel der Fig. 2 ein erster Modulator 131, ein zweiter Modulator 132 und ein Schalter 133 ausgebildet. Der Schalter 133 überbrückt den Vorwiderstand Rg. Daher wird in einer Beschaltung gemäß der Erfindung dieser Vorwiderstand Rg, der im Stand der Technik fest war (siehe auch Fig. 19), dynamisch verändert. Der erste Modulator 131 ist zwischen einem Anschluss für eine nominelle Gate-Spannung Vg,nom und dem Anschluss für die Gate-Spannung Vg geschaltet und wird durch ein erstes Steuersignal Vg,ctrl für die Gate-Spannung derart gesteuert, dass an dem Anschluss für die Gate-Spannung Vg entweder die nominelle Gate-Spannung Vg,nom oder aber ein Nullpotential anliegt. Der zweite Modulator 132 ist zwischen dem Anschluss für die Versorgungsspannung Vd (z.B. Drain-Spannung am Transistor 115) und einem Anschluss für die nominelle Versorgungsspannung Rx-Supply geschaltet. Der zweite Modulator ist ebenfalls ausgebildet, um ansprechend auf ein entsprechendes zweites Steuersignal Vd,ctrl den Anschluss für die Versorgungsspannung Vd entweder auf ein Nullpotential oder die nominelle Versorgungsspannung RxSupply zu setzen. Um das Nullpotential zu erreichen kann der erste und/oder zweite Modulator 131, 132 außerdem an Masse angeschlossen sein (nicht in Fig. 2 gezeigt).

Fig. 2 stellt somit idealisiert und stark vereinfacht das Prinzip des Verfahrens gemäß der Erfindung dar. Während der Stressbelastung werden mit Hilfe von Signal-Modulatoren 131, 132 sowohl die vom Modul dem Verstärker bereitgestellte Drain-Spannung Vd als auch die bereitgestellte Gate-Spannung Vg zu null erzwungen. Um diese Bedingungen auch am Transistor 115 selbst zu gewährleisten, wird während der Stressbelastung der Vorwiderstand Rg durch den Schalter 133 überbrückt. An diesen Schalter 133 werden bei beispielhaften Pulsradaren mit kurzen Wiederholraten große Anforderungen an die Schaltzeit gestellt. Je nach Technologie wird dafür außerdem eine zusätzliche, üblicherweise negative Spannung benötigt, durch die die Komplexität der Schaltung weiter ansteigt.

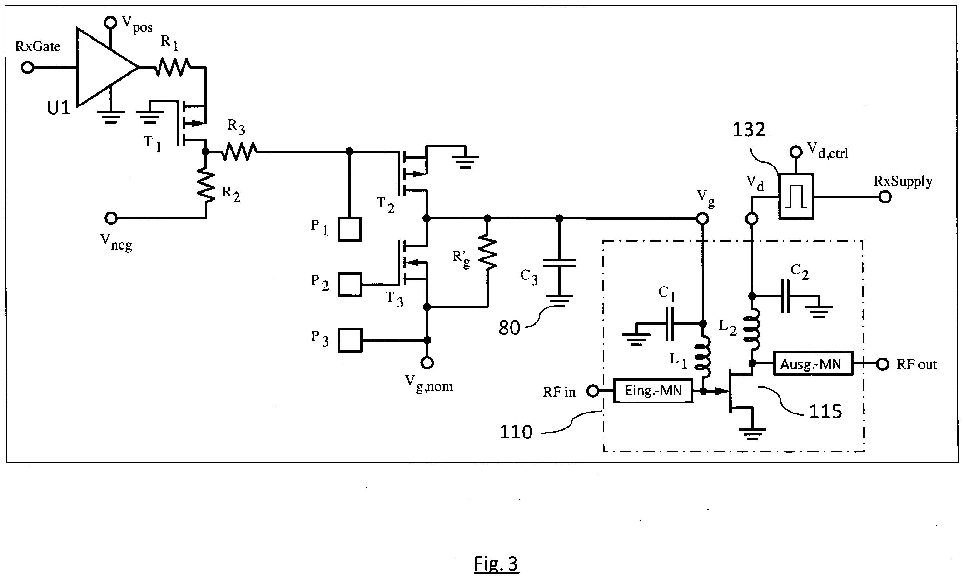

Fig. 3 stellt eine Schaltungsanordnung gemäß einem Beispiel dar, welche keine zusätzliche negative Spannung benötigt. In dieser Schaltungsanordnung umfasst der Verstärker 110 folgende Elemente: das eingangsseitiges Anpassungsnetzwerk 116, den Transistor 115, das ausgangsseitiges Anpassungsnetzwerk 118, erste und zweite Kapazitäten C1, C2 als auch erste und zweite Induktivitäten L1, L2. Diese Elemente sind zwischen dem Eingang 112, dem Ausgang 114 und der Massen 80 geschaltet, wie es in der Fig. 2 oder der Fig. 19 dargestellt ist. Außerdem umfasst das Ausführungsbeispiel den zweiten Modulator 132 zwischen dem Anschluss für die Drain-Spannung Vd und dem Anschluss für die nominelle Versorgungsspannung RxSupply.

Alle übrigen Bauelemente bilden ein Ausführungsbeispiel für den ersten Modulator 131, der zwischen einem Anschluss für die Gate-Spannung Vg und dem Anschluss für die nominelle Gate-Spannung Vg,nom geschaltet ist und durch das digitalen Steuersignal RxGate (entsprechend zu Vg,ctrl aus der Fig. 2) gesteuert wird. Der erste Modulator 131 umfasst daher: einen ersten Operationsverstärker U1, einen ersten Transistor T1, einen zweiten Transistor T2, einen dritten Transistor T3, einen ersten Widerstand R1, einen zweiten Widerstand R2, einen dritten Widerstand R3, einen Vorwiderstand Rg' und eine dritte Kapazität C3. Die Widerstandswerte vom Vorwiderstand Rg' und dem Vorwiderstand Rg aus der Fig. 2 können sich unterscheiden, daher wurde ein anderes Symbol gewählt.

Der dritte Transistor T3 ist zwischen dem Anschluss für die nominelle Gate-Spannung Vg,nom und dem Anschluss für die Gate-Spannung Vg geschaltet, wobei der Steueranschluss (Punkt P2) des dritten Transistors T3 verschieden geschaltet sein kann. Der Vorwiderstand Rg' überbrückt den dritten Transistor T3 und ist somit ebenfalls zwischen dem Anschluss für die nominelle Gate-Spannung Vg,nom und dem Anschluss für die Gate-Spannung Vg geschaltet. Die dritte Kapazität C3 ist zwischen dem Anschluss für die Gate-Spannung Vg und der Masse 80 geschaltet. Der zweite Transistor T2 ist zwischen dem Anschluss für die Gate-Spannung Vg und Masse 80 geschaltet. Der Steueranschluss des zweiten Transistors T2 ist über den ersten Transistor T1 mit dem Ausgang des ersten Operationsverstärkers U1 elektrisch verbunden, wobei zwischen dem ersten Transistor T1 und dem ersten Operationsverstärker U1 der erste Widerstand R1 geschaltet ist und zwischen dem ersten Transistor T1 und dem Steueranschluss des zweiten Transistors T2 der dritte Widerstand R3 geschaltet ist. Außerdem ist der erste Transistor T1 mit dem Anschluss, der an dem dritten Widerstand R3 koppelt, ebenfalls über den zweiten Widerstand R2 mit dem Anschluss für die negative Versorgungsspannung Vneg verbunden. Der erste Operationsverstärker U1 erhält an seinem Eingang das digitale Steuersignal RxGate und weist einen Anschluss für die positive Versorgungsspannung Vpos und einen Anschluss für das Massepotential 80 auf.

Diese Schaltungsanordnung besteht somit einerseits aus dem Verstärker 110 (der beispielhafte LNA) ähnlich dem Stand der Technik (siehe Fig. 19), der beispielsweise als integrierte Mikrowellenschaltung (engl. monolithic microwave integrated circuit, MMIC) in GaN-Technologie ausgeführt sein kann, jedoch in Abgrenzung dazu keinen Vorwiderstand Rg enthält. Dies ist vorteilhaft, da der (feste) Vorwiderstand Rg im Verstärker 110 für den Ansatz gemäß der Erfindung eher contra-produktiv ist, da er bei Auftreten eines Gate-Stroms verhindert, dass der Potentialunterschied zwischen Gate und Source des HF-Transistors 115 zu null erzwungen werden kann.

In der Fig. 3 ist der Verstärker 110 durch den strichpunktierten Kasten dargestellt. Weiterhin besteht die Schaltungsanordnung aus einem Ansteuerungsteil (erster Modulator 131 und zweiter Modulator 132), der auf einem HF-Schaltungsträger (durchgezogener äußerer Kasten), beispielsweise einem Mehrlagen-Keramik-Substrat (engl. Low temperature cofired ceramic, LTCC), realisiert sein kann. Der Ansteuerungsteil, wie er zuvor beschrieben wurde, gliedert sich in einen Teil zur zeitlichen Modulation der Versorgungsspannung Vd, RxSupply (durch zweiten Modulator 132) und einen Teil zur zeitlichen Modulation der Steuerspannung Vg (durch ersten Modulator 131) und arbeite wie folgt. Während das digitale Steuersignal RxGate den logischen Wert "1" (logisch eins) liefert, wird der Verstärker 110 mit der nominellen Gate-Spannung Vg,nom angesteuert. Bei einem Zustandswechsel des Steuersignals RxGate auf den logischen Wert "0" (logisch null) wird mit Hilfe der Ansteuerschaltung die Steuerspannung Vg durch sperren des Schalt-Transistors T2 gegen Masse kurzgeschlossen.

Um dies zu erreichen, können die Transistoren T1, T2, T3 beispielsweise selbstsperrende Transistoren sein, wobei der zweite Transistor T2 komplementär zu dem dritten Transistor T3 ist. Beispielsweise kann der zweite Transistor T2 ein p-Kanal-Transistor sein (so dass er bei einem entsprechend positiven Gate-Potential sperrt), während der dritte Transistor T3 ein n-Kanal-Transistor ist (so dass er bei einem entsprechend negativen Gate-Potential sperrt). Der erste Transistor T1 kann ebenfalls ein p-Kanal Transistor sein. Es versteht sich, dass die in den Figuren dargestellten Leitungstypen der Transistoren und/oder Polaritäten lediglich Beispiele darstellen und dass die Erfindung nicht auf die spezifischen Leitungstypen eingeschränkt sein soll. Für einen Fachmann ist offensichtlich, dass die Kanaltypen der Transistoren und/oder die Polaritäten für die verschiedenen Spannungen derart geändert werden, dass das gleiche Resultat (Abschalten des Verstärkers) erreicht wird. Ebenso können die Drain- und Source-Anschlüsse in den Schaltungen vertauscht werden.

Durch eine geeignete externe Beschaltung und logische Verknüpfung der Steuersignale RxGate und Vd,ctrl kann unter Berücksichtigung von Signallaufzeiten und nichtidealen Zustandsänderungen der Signale sichergestellt werden, dass während der gesamten Zeit, zu der die Gate- oder Steuerspannung Vg gegen Masse kurzgeschlossen ist, die Drain-Spannung Vd ebenfalls 0V beträgt.

Diese Schaltungsanordnung kann auf unterschiedliche Arten betrieben werden:

1. In einer ersten Betriebsart sind die Punkte P2 (koppelt an dem Steueranschluss vom dritten Transistor T3) und P3 (koppelt an den Anschluss für die nominelle Gate-Spannung Vg,nom) elektrisch verbunden. In dieser Beschaltung wird die nominelle Gate-Spannung Vg,nom dem Verstärker 110 über den Vorwiderstand R'g zugeführt (Vg,nom ist im Normalbetrieb negativ und sperrt den n-Kanal Transistor T3). Dadurch wird im Rx-Fall (Empfangsbetrieb) eine sehr große Robustheit gegen Übersteuerung gewährleistet. Dieser Vorwiderstand R'g wirkt sich jedoch nachteilig auf die Schaltflanke im Anschluss an die HF-Übersteuerung aus, da der HF-Block-Kondensator C3 über den Vorwiderstand R'g umgeladen werden muss.

2. In einer zweiten Betriebsart sind die Punkte P1 (koppelt an den Gate-Anschluss des zweiten Transistors T2) und P2 elektrisch verbunden. Somit wirken der erste und zweite Transistor T2, T3 als komplementäre Schalter, die wechselweise öffnen und schließen. Damit wird in beiden Zuständen die erforderliche Spannung niederohmig dem Gate des HF-Transistors 115 im Verstärker 110 zugeführt und es sind so nahezu ideale Schaltflanken möglich. Da jedoch während dem nominellen Rx-Betrieb (Empfangsbetrieb) der Schalt-Transistor T3 geschlossen ist und somit der Vorwiderstand R'g überbrückt wird, können bei sehr großer HF-Übersteuerung Gate-Ströme auftreten, die die Robustheit des Verstärkers 110 einschränken.

3. In einer dritten Betriebsart wird am Punkt 2 ein zusätzliches digitales Steuersignal in Form eines kurzen Impulses benötigt. Dieses Steuersignal bewirkt, dass der Vorwiderstand R'g nur für kurze Zeit zum Umladen des HF-Block-Kondensators C3 überbrückt wird. In dieser Betriebsart werden sowohl schnelle Schaltzeiten zwischen den Zuständen, als auch eine hohe Robustheit gegen HF-Übersteuerung im Rx-Betrieb gewährleistet. Das Steuersignal an Punkt 2 kann durch eine geeignete Schaltung auch aus dem Steuersignal RxGate abgeleitet werden.

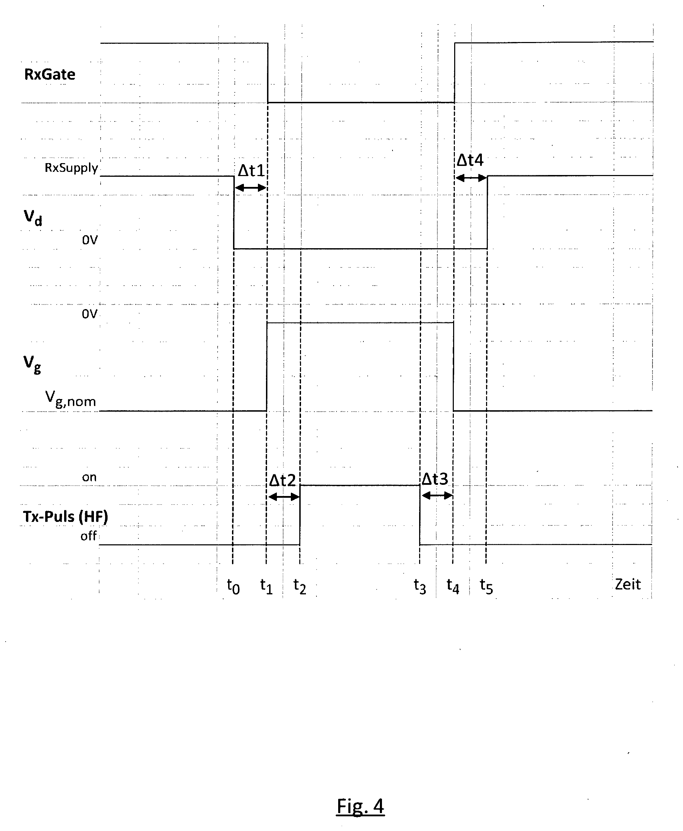

**Fig. 4** veranschaulicht den logischen Zusammenhang und die zeitliche Abfolge der einzelnen Signale in idealisierter Form. Dazu sind in der Fig. 4 folgende Zeitverläufe (als eine ideale zeitliche Abfolge) dargestellt: oben ein Spannungsverlauf für das digitale Steuersignal für den Empfangspfad RxGate, darunter ein Spannungsverlauf für die Drain-Spannung Vd, darunter ein Spannungsverlauf für die Gate-Spannung Vg und unten ein Spannungsverlauf für ein Sendesignal Tx-Puls (HF-Sendepuls).

Wie aus der Fig. 4 zu entnehmen ist, bewirkt das Ändern des digitalen Steuersignals RxGate von logisch eins zu logisch null, dass die Gate-Spannung Vg auf ein Nullpotential (0V) gesetzt wird. Dies wird in der Schaltung der Fig. 3 dadurch erreicht, dass der Ausgang des ersten Operationsverstärker U1 auf Masse liegt, so dass der zweite Transistor T2 sich schließt (negative Spannung am Gate) und der Anschluss für die Steuerspannung Vg somit auf Masse gesetzt wird.

Außerdem zeigt die Fig. 4 ein beispielhaftes Sendesignal Tx-Puls, das innerhalb jenes Bereiches fällt, bei dem die Gate-Spannung Vg und die Drain-Spannung Vd auf dem Nullpotential liegen. Gemäß Ausführungsbeispielen wird sichergestellt, dass die Drain-Spannung Vd und die Gate-Spannung Vg bereits vor dem Beginn (und noch nach dem Ende) des Sendesignal Tx-Pulses 0V aufweisen. Somit werden gemäß Ausführungsbeispielen in einem zeitlichen Abstand Δt1 vor dem Umschalten des digitalen Steuersignals RxGate auf logisch null die Versorgungsspannung Vd von dem Wert RxSupply auf ein Nullpotential gelegt. Ebenfalls erfolgt das Zurücksetzen der Drain-Spannung Vd auf den Spannungswert RxSupply um einen vierten zeitlichen Abstand Δt4 später als das Zurücksetzen der Gate-Spannung Vg. Ebenfalls ist gemäß Ausführungsbeispielen die ansteigende Flanke als auch die abfallende Flanke des Sendesignals Tx-Puls von den Flanken der Gate-Spannung Vg beabstandet, und zwar um einen zweiten zeitlichen Abstand Δt2 für die ansteigende Flanke und um einen dritten zeitlichen Abstand Δt3 für die abfallende Flanke.

Die so definierten Schutzzeiten Δti, i=1,2... (engl. guard times) zwischen den Zustandsänderungen der einzelnen Signale stellen sicher, dass während der ganzen Zeit, zu der die Gate-Spannung Vg gegen Masse kurzgeschlossen ist, die Drain-Spannung Vd ebenfalls 0V beträgt. Hierfür sind insbesondere Umlade-Effekte und die daraus resultierenden realen Schaltflanken sowie Laufzeiten der unterschiedlichen Signale zu berücksichtigen.

Die Ursache für eine Beeinflussung des Empfangsverhaltens durch HF-Übersteuerung kann selbstverschuldet und somit a priori bekannt sein. Beispiele hierfür sind etwa die Leck-Leistung im Sendebetrieb infolge der begrenzten Isolation des T/R-Schalters sowie Reflektionen (z.B. an einem Radom von Radaranlagen). Um dieser Beeinflussung wirksam zu begegnen, kann der Verstärker 110 während des Sendepulses Tx-Puls grundsätzlich in den oben beschriebenen (kritischen) Zustand versetzt werden. Dies kann beispielsweise mit der in Fig. 3 angegebenen Schaltungsanordnung geschehen (z.B. über das digitale oder erste Steuersignal RxGate und zweite Steuersignal Vd,ctrl).

Es gibt jedoch auch Situationen, in denen die HF-Übersteuerung nicht a priori bekannt ist, zum Beispiel weil sie von fremden Sendern (z.B. fremde Radare) verursacht werden, sei es bewusst zum Zweck von Electronic Counter Measures (ECM) oder unbewusst durch andere Sendeeinrichtungen (z.B. Radaranlagen). In diesen Situationen sind die HF-Übersteuerung zu erkennen, um dann die erforderlichen Gegenmaßnahmen einleiten zu können.

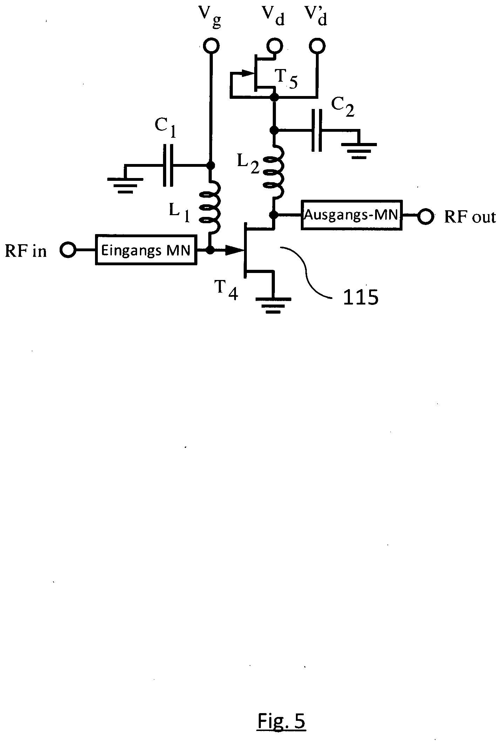

**Fig. 5** zeigt ein Ausführungsbeispiel für die Schaltungsanordnung, die der Detektion der HF-Übersteuerung am Eingang dient. In dem gezeigten Ausführungsbeispiel wird die Übersteuerung durch ein Überschreiten eines Stromes durch den Transistor 115 (T4) detektiert. Dazu ist zwischen dem Anschluss für die Drain-Spannung Vd und der zweiten Induktivität L2 ein fünfter Transistor T5 geschaltet, wobei zwischen dem fünften Transistor T5 und der zweiten Induktivität L2 eine interne Drain-Spannung V'd abgegriffen wird. Dadurch kann der Spannungsabfall über dem fünften Transistor T5 erfasst werden, der ein Maß für den Strom ist, der von dem Transistor 115 durch die zweite Induktivität L2 hin zu dem Anschluss für die Drain-Spannung Vd fließt (oder in umgekehrter Richtung). Alle weiteren Elemente, wie sie in der Fig. 5 zu sehen sind, entsprechen den Elementen des Verstärkers 110, wie sie bereits in der Fig. 3 oder 2 beschrieben wurden.

In dieser Schaltung kann der fünfte Transistor T5 derart dimensioniert werden, dass der Drain-Strom bei einer HF-Übersteuerung des HF-Transistors T4 (115) auf einen festgelegten Strom begrenzt ist (den Sättigungsstrom dieses Transistors). Die dabei auftretende Spannungsdifferenz zwischen den beiden Anschlüssen Vd und V'd kann zur Detektion der HF-Übersteuerung genutzt werden, um basierend darauf den Verstärker 110 wie zuvor beschrieben in den Zustand zu versetzen, in dem die HF-Übersteuerung keine nachteilige Auswirkung auf die Eigenschaften des Verstärkers 110 bewirkt. Der fünfte Transistor T5 ist beispielsweise kompatibel zu der Technologie, in der der Verstärker 110 ausgeführt ist (beispielsweise MMIC in GaN-Technologie), und kann somit Bestandteil des LNA-MMIC sein.

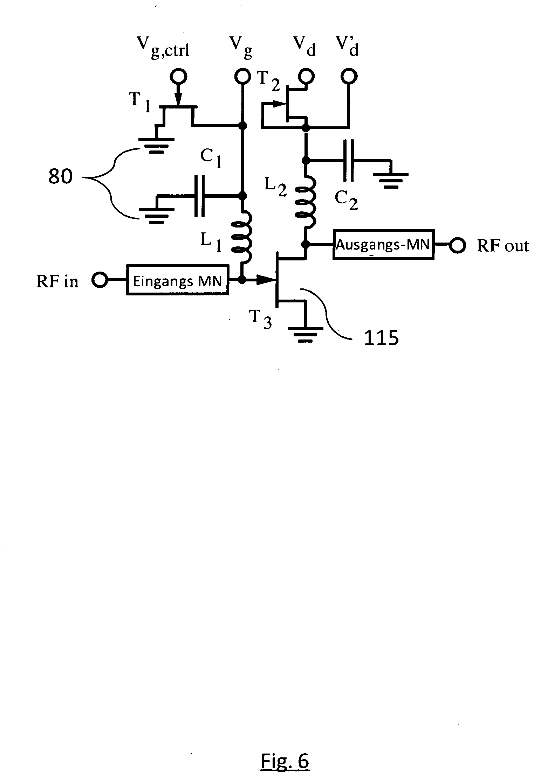

**Fig. 6** zeigt ein Ausführungsbeispiel eines Verstärkers, bei welchem zwischen dem Anschluss für die Gate-Spannung Vg und der Masse 80 ein Schalt-Transistor T1 als Schutzschaltung gegen HF-Übersteuerung geschaltet ist, wobei an dessen Steueranschluss das erste Steuersignal Vg,ctrl anlegbar ist. Somit wird der Anschluss für die Steuerspannung Vg bei Vorliegen eines entsprechenden ersten Steuersignals Vg,ctrl, welches den ersten Transistor T1 schließt, auf Masse 80 gelegt.

Die gezeigte Schaltungsanordnung kann als eine Alternative zur Implementierung aus der Fig. 3 genommen werden, bei der Teile der Gate-Ansteuerschaltung auch direkt auf dem LNA-MMIC realisiert sind. In dem Ausführungsbeispiel der Fig. 6 ersetzt der Schalt-Transistor T1 funktional den zweiten Transistor T2 aus der Fig. 3. Durch die Ausführung in unmittelbarer Nähe zu dem Gate-Anschlusses des rauscharmen HF-Transistors T3 (115), wirkt der Schalt-Transistor T1 besonders gut, d.h. es können sehr kurze Schaltflanken realisiert werden. Infolge geringer parasitärer Anteile kann außerdem der Kurzschluss gegen Masse 80 in guter Näherung gewährleistet werden. Als Folge daraus ist eine besonders gute Verträglichkeit bezüglich HF-Übersteuerung zu erwarten.

Für die Ausprägung des Verstärkers 110 gemäß dem Ausführungsbeispiel der Fig. 6 ist jedoch eine besondere Ansteuerschaltung zur Generierung des Steuersignals Vg,ctrl vorteilhaft. Diese Ansteuerschaltung sollte dazu den folgenden funktionalen Zusammenhang erfüllen:

wenn: $Vd-V'd > \Delta Vd,sw1$ , dann: $Vg,ctrl = 0V$,

wenn: $Vd-V'd < \Delta Vd,sw2$ , dann:

$$Vg,ctrl=Vpo+Vg,nom.$$

Darin sind die Eingangsgrößen Vd und V'd die in Fig. 6 angegebene, vom Modul bereitgestellte Drain-Spannung Vd und die hinter dem den Strom begrenzenden Transistor T2 gemessene interne Drain-Spannung V'd. $\Delta Vd,sw1$, $\Delta Vd,sw2$ sind Schwellwertgrößen, die passend zur Technologie und zu den Anforderungen an das Modul hinsichtlich Leistungsverträglichkeit auszulegen sind. Vorteilhafterweise gilt: $\Delta Vd,sw1 > \Delta Vd,sw2$ , um ein Schwingungsverhalten zwischen beiden Zuständen zu vermeiden. Die Größe Vpo ist die Abschnürspannung (engl. Pinch-off voltage) vom ersten Transistor T1, d.h. jene Gate-Spannung, ab der ein Transistor in der betrachteten Technologie vollständig sperrt, und ist damit eine charakteristische Kenngröße der verwendeten Halbleitertechnologie. Vg,nom ist die nominelle Gate-Spannung, die während des regulären Empfangsbetriebs den Arbeitspunkt des Verstärkers 110 festlegt. Da sowohl Vpo als auch Vg,nom negative Spannungen sind, muss die im HF-Übersteuerungsfall bereitgestellte Kontrollspannung Vg,ctrl,od (engl. over drive) entsprechend ausgelegt werden.

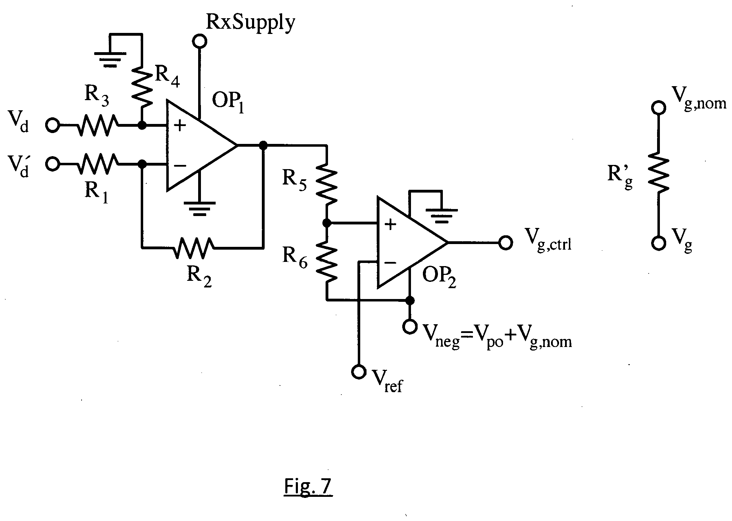

**Fig. 7** zeigt ein Ausführungsbeispiel für eine Ansteuerschaltung zum Schutz des Verstärkers vor HF-Übersteuerung. Die Ansteuerschaltung wertet den Unterschied zwischen der Drain-Spannung Vd und der internen Drain-Spannung V'd aus, um basierend darauf das erste Steuersignal Vg,ctrl für die Gate-Spannung Vg zu erzeugen.

Die Verschaltung aus der Fig. 7 (linke Seite) umfasst einen ersten Operationsverstärker OP1, einen zweiten Operationsverstärker OP2 und sechs Widerstände R1, R2, ... R6.

Der erste Operationsverstärker OP1 ist beispielsweise an seinem nicht-invertierten Eingang ("+" Eingang) über den dritten Widerstand R3 mit dem Anschluss für die Drain-Spannung Vd verbunden und mit seinem invertierten Eingang ("-" Eingang) über den ersten Widerstand R1 mit dem Anschluss für die interne Drain-Spannung V'd verbunden. Der erste Operationsverstärker OP1 ist außerdem mit seinem ersten Versorgungsanschluss an den Anschluss für die nominelle Versorgungsspannung RxSupply gekoppelt und mit seinem zweiten Versorgungsanschluss an Masse 80. Zwischen dem invertierten Eingang des ersten Operationsverstärkers OP1 und dem Ausgang des ersten Operationsverstärkers OP1 ist der zweite Widerstand R2 geschaltet. Zwischen dem nicht-invertierten Eingang des ersten Operationsverstärkers OP1 und Masse ist der vierte Widerstand R4 geschaltet.

Der Ausgang des ersten Operationsverstärkers OP1 ist über den fünften Widerstand R5 mit dem nicht-invertierten Eingang des zweiten Operationsverstärkers OP2 verbunden. Der invertierte Eingang des zweiten Operationsverstärkers OP2 ist mit einem Anschluss für eine Referenzspannung Vref verbunden. Der Ausgang des zweiten Operationsverstärkers OP2 liefert die erste Steuerspannung Vg,ctrl. Außerdem ist der zweite Operationsverstärker OP2 mit seinem ersten Versorgungsanschluss auf Masse und mit seinem zweiten Versorgungsanschluss auf die negative Versorgungsspannung

Vneg gelegt. Zwischen dem nicht-invertierten Eingang des zweiten Operationsverstärkers OP2 und dem Anschluss für die negative Versorgungspannung Vneg ist der sechste Widerstand R6 geschaltet.

Gemäß dem in der Fig. 7 (rechte Seite) gezeigten Ausführungsbeispiel ist der Anschluss für die Gate-Spannung Vg und der Anschluss für die nominelle Gate-Spannung Vg,nom mittels eines Vorschaltwiderstandes R'g verbunden.

Die Schaltung der Fig. 7 genügt dem funktionalen Zusammenhang, der an das Steuersignal Vg,ctrl in der Fig. 6 gestellt wird. RxSupply, Vneg und Vref sind die vom Modul bereitgestellte Versorgungspannung des Empfangspfads, die negative Versorgungsspannung sowie die Referenzspannung, die wiederum per Widerstandsnetzwerk aus RxSupply und Vneg erzeugt sein kann. Die Widerstände R1...R6 sind entsprechend den festgelegten Größen ΔVd,sw1 und ΔVd,sw2, Vpo und Vg,nom geeignet auszulegen. R'g begrenzt einerseits unerwünschte Querströme im Übersteuerungsfall und erhöht andererseits die Verträglichkeit des Verstärkers 110 bezüglich Empfangssignalen mit moderaten Leistungspegeln, bei denen die Gate-Ansteuerschaltung noch nicht anspricht.

Die Schaltungsteile in Fig. 6 und in Fig. 7 zusammen genommen ergeben eine Schaltungsanordnung, die vor a priori unbekannter HF-Übersteuerung wirksam schützt.

Die bisher gezeigten Ausführungsbeispiele nutzen die erhöhte Stromaufnahme des Verstärkers 110, um die Übersteuerung zu detektieren.

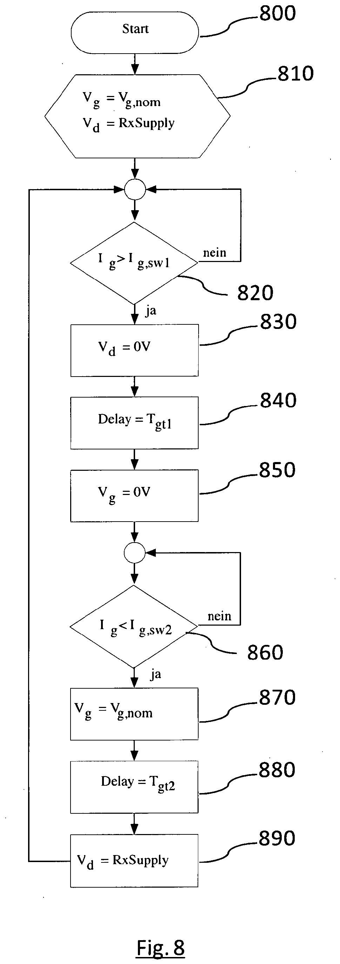

Fig. 8 zeigt einen Programmablaufplan für ein Verfahren zur Verbesserung der Verträglichkeit von Empfangssignalen mit großem Leistungspegel. In dem gezeigten Ausführungsbeispiel wird eine Auswirkung der HF-Übersteuerung auf den Gate-Strom ausgenutzt, um die HF-Übersteuerung zu detektieren und anschließend den Verstärker 110 in den zuvor beschriebenen sicheren Zustand zu versetzen.

Nach einem Start (Schritt 800) und der Initialisierung (Schritt 810) des Verstärkers 110 mit den nominellen Werten für die Gate- und Drain-Spannung wird zunächst der gemessene Gate-Strom Ig mit einem festgelegten Schwellwert Ig,sw1 verglichen (Schritt 820). Sobald der gemessene Wert den Schwellwert übertrifft, wird die Versorgungspannung abgeschaltet (Schritt 830). Nach einer Schutzzeit Tgt1 (Schritt 840) wird auch die Gate-Spannung Vg zu 0 V erzwungen (Schritt 850). Daraufhin wird so lange abgewartet, bis der Gate-Strom einen zweiten Schwellwert Ig,sw2 unterschreitet (Schritt 860). Wird dieser zweite Schwellwert unterschritten, wird zunächst wieder die nominelle Gate-Spannung eingestellt (Schritt 870). Nach Ablauf einer weiteren Schutzzeit Tgt2 (Schritt 880) wird auch die nominelle Versorgungsspannung RxSupply wieder angelegt (Schritt 890).

Hierbei ist sicherzustellen, dass während der Zustandsänderungen des Verstärker-Bias (z.B. Spannung am Gate) die Versorgungspannung Vd des Verstärkers 110 abgeschaltet ist. Dies wird durch einstellbare Schutzzeiten Tgt1, Tgt2 (engl. guard times) im Programmablaufplan gewährleistet.

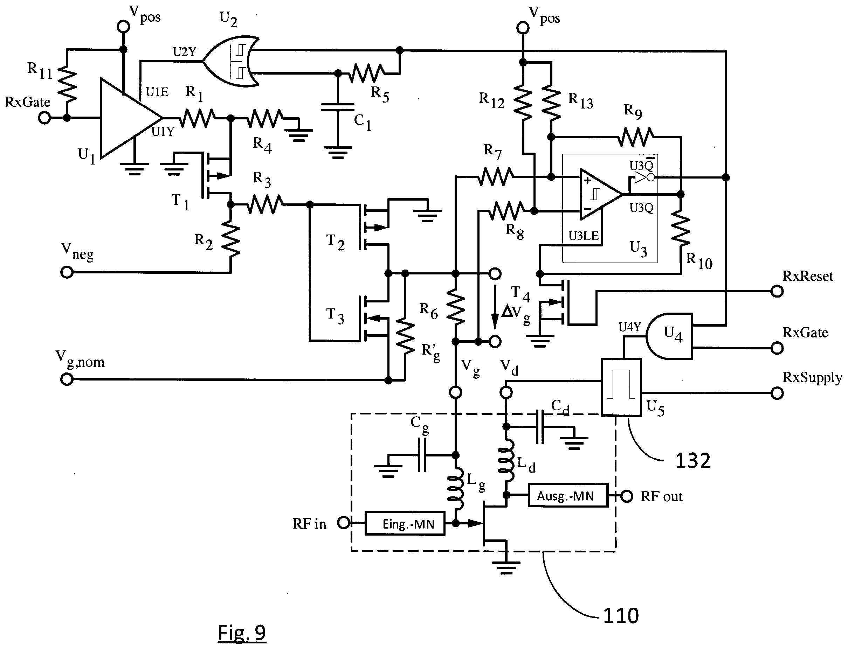

Fig. 9 zeigt eine Schaltungsanordnung gemäß einem Beispiel zur Detektion einer HF-Übersteuerung mittels einer Überwachung des Gate-Stroms und Schutz vor HF-Übersteuerung als eine praktische Implementierung dieses Verfahrens.

In der gezeigten Verschaltung koppelt der Verstärker 110 (der sich nicht von den zuvor beschriebenen Verstärkern unterscheidet) an den Versorgungsanschluss für die Gate-Spannung Vg und den Anschluss für die Drain-Spannung Vd. Die Verschaltung der Fig. 9 umfasst weiter einen Puffer-Verstärker U1, ein ODER-Gatter U2 (mit Schmitt-Trigger Eingängen), einen Komparator U3 und ein UND-Gatter U4. Außerdem umfasst die Verschaltung: einen ersten, zweiten ... dreizehnten Widerstand R1, R2, ... R13, einen ersten bis vierten Transistor T1 ... T4 und eine erste Kapazität C1.

Zwischen dem Anschluss für die Steuerspannung Vg und dem nicht-invertierten Eingang des Komparator U3 sind in Serie der sechste Widerstand R6 und der siebte Widerstand R7 angeordnet, wobei über den sechsten Widerstand R6 ein Steuerspannungsabfall ΔVg abgegriffen wird und an den Eingang des Komparators U3 koppelt, d.h. der invertierte Eingang des Komparators U3 ist über den achten Widerstand R8 mit dem Anschluss für die Gate-Spannung Vg verbunden. Außerdem ist der invertierte Eingang des Komparators U3 über den zwölften Widerstand R12 mit der positiven Versorgungsspannung Vpos verbunden. Der nicht-invertierte Eingang des Komparators U3 ist über den dreizehnten Widerstand R13 ebenfalls mit der positiven Versorgungsspannung Vpos verbunden.

Der Ausgang des Komparators U3 ist seriell über den zehnten Widerstand R10 und den vierten Transistor T4 mit Masse verbunden. Der Steueranschluss des vierten Transistors T4 koppelt an einen Rücksetzsignaleingang RxReset. Außerdem ist der Sperrungsanschluss (engl. latch enable, LE) des Komparators U3 mit einem Knoten zwischen dem zehnten Widerstand R10 und dem vierten Transistor T4 verbunden. Der Ausgang des Komparators U3 ist weiter über den neunten Widerstand R9 mit dem nicht-invertierten Eingang des Komparators U3 verbunden.

Der invertierte Ausgang U3Q des Komparators U3 ist weiter mit einem Eingang des UND-Gatters U4 verbunden, wobei der andere Eingang des UND-Gatters U4 das digitale Steuersignal RxGate erhält. Der Ausgang des UND-Gatters U4 ist mit dem Steuereingang des zweiten Modulators 132 (U5) verbunden und liefert ein Steuersignal U4Y an den zweiten Modulator 132. Der Anschluss für die Drain-Spannung Vd ist über den zweiten Modulator 132 (U5) mit der nominelle Versorgungsspannung RxSupply verbunden.

Außerdem ist der invertierte Ausgang U3$\overline{Q}$ des Komparators U3 mit einem Eingang des ODER-Gatters U2 verbunden. Der weitere Eingang des ODER-Gatters U2 ist über die erste Kapazität C1 auf Masse gelegt und außerdem über den fünften Widerstand R5 mit dem invertierten Ausgang des Komparators U3 verbunden. Der Ausgang des ODER-Gatters U2 ist mit einem Aktivierungseingang des Puffer-Verstärkers U1 verbunden, wobei der obere Versorgungseingang mit der positiven Versorgungspannung Vpos verbunden ist und der untere Versorgungseingang des Puffer-Verstärker U1 auf Masse liegt.

Der Eingang des Puffer-Verstärker U1 koppelt an das digitale Steuersignal RxGate und über den elften Widerstand R11 an die positive Versorgungsspannung Vpos. Der Ausgang des Puffer-Verstärkers U1 ist über den ersten Widerstand R1 und den vierten Widerstand R4 in dieser Reihenfolge mit Masse verbunden. Zwischen dem ersten Widerstand R1 und dem vierten Widerstand R4 ist ein Strompfad über den ersten Transistor T1, den zweiten Widerstand R2 zu der negativen Versorgungsspannung Vneg ausgebildet. Der Steueranschluss des ersten Transistors T1 liegt auf Masse. Zwischen dem ersten Transistor T1 und dem zweiten Widerstand R2 zweigt ein Strompfad ab, der eine Verbindung über den dritten Widerstand R3 zu dem Steueranschluss des zweiten Transistors T2 als auch über den dritten Widerstand R3 zu dem Steueranschluss des dritten Transistors T3 herstellt.

Der zweite Transistor T2 und der dritte Transistor T3 sind seriell zwischen Masse und dem Anschluss für die nominelle Gate-Spannung Vg,nom ausgebildet, wobei der zweite Transistor T2 und der dritte Transistor T3 komplementär zueinander sind. Zwischen dem Anschluss für die nominelle Gate-Spannung Vg,nom und einem Knoten zwischen dem zweiten Transistor T2 und dem dritten Transistor T3 ist der Vorwiderstand R'g ausgebildet, der somit den dritten Transistor T3 überbrückt. Außerdem ist der Knoten zwischen dem zweiten Transistor T2 und dem dritten Transistor T3 mit einem Knoten zwischen dem sechsten Widerstand R6 und dem siebten Widerstand R7 verbunden.

Die Funktionsweise dieser Schaltung kann wie folgt zusammengefasst werden. Die HF-Übersteuerung wird als Anstieg des Spannungsabfalls ΔVg über den sechsten Widerstand R6 von der Komparator-Schaltung U3 detektiert. Die Rückkopplung mittels R10 auf den Sperrungs-Eingang von U3 (engl: latch enable, U3LE) stellt sicher, dass nach der Detektion einer HF-Übersteuerung die Schaltung im "Schutzmodus" gehalten wird und erst durch einen Auslöse-Impuls des "RxReset" wieder in den nominellen Rx-Betrieb zurückkehrt. Alternativ dazu kann auch die Schmitt-Trigger-Eigenschaft des Komparators U3 genutzt werden, um bei einem Unterschreiten der Spannungsdifferenz ΔVg unter den Schwellwert ΔVg,sw2 automatisch wieder in den nominellen Rx-Betrieb zurückzukehren. Hierzu bleibt der zehnte Widerstand R10 einfach unbestückt. Der Komplementär-Ausgang von U3 (U3Q) stellt im Zustand "low" mit Hilfe des UND-Gatters U4 und des Rx-Modulators U5 (132) sicher, dass die Drain-Spannung des Verstärkers 110 abgeschaltet ist.

Mit den Bauteilen U2/R5/C1 wird ein Verzögerungsglied realisiert, bei dem nur die fallende Flanke, nicht jedoch die ansteigende Flanke verzögert wird. Die Zustandsänderung vom nominellen Rx-Betrieb zu einer HF-Übersteuerung wird somit dem Aktivierungseingang U1E des Puffer-Verstärkers U1 zeitverzögert übermittelt. So wird sichergestellt, dass die Gate-Spannung des Verstärkers 110 erst dann zu 0 V erzwungen wird, wenn die Drain-Spannung bereits 0 V beträgt. Dazu ist der Puffer-Verstärker U1 mit einem 3-state-Ausgang versehen, der bei einem logisch null-Pegel am Aktivierungseingang U1E hochohmig und damit von der externen Beschaltung bestimmt wird. Da der Widerstand R4 gegen Masse geschaltet ist, wird in diesem Fall U1Y (Ausgang vom Puffer-Verstärker U1) ebenfalls den 0V-Zustand annehmen. Die Schutzzeit zwischen den beiden Zustandsänderungen ist per Verzögerungszeit durch Dimensionierung von R5/C1 einstellbar. Die Bauteile T1, T2, T3, R2, R3 bewirken eine Pegelwandlung vom positiven Spannungsbereich 0 V ... Vpos der Ansteuerlogik in den negativen Spannungsbereich 0 V ... Vg,nom der Gateansteuerung. Dabei ist die nominelle Gate-Spannung Vg,nom die von der Modulelektronik bereitgestellte Gate-Bias-Spannung für den nominellen Rx-Betrieb.

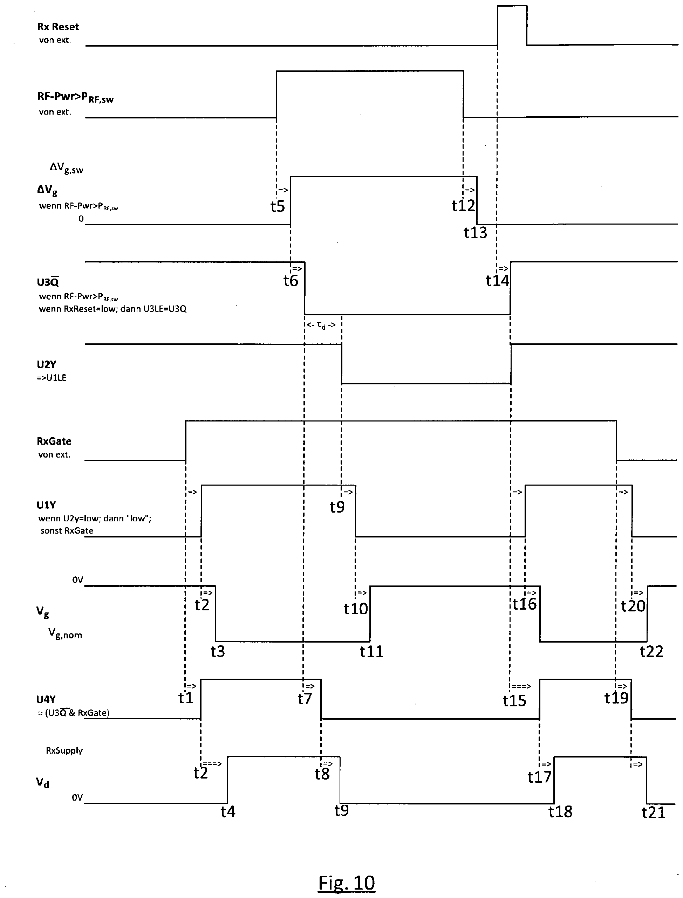

**Fig.** 10 zeigt ein Zeitdiagramm für die unterschiedlichen Signale, die zwischen den Bauteilen, wie sie in der Fig. 9 zu sehen sind, übertragen werden. Von oben nach unten sind folgende Signale dargestellt: zunächst das Empfangsrücksetzsignal RxReset, welches extern eingegeben werden kann, darunter ein beispielhaftes Empfangssignal RF-pwr, darunter die Spannungsdifferenz ΔVg, darunter das invertierte Ausgangssignal U3Q des Komparators U3, darunter das Ausgangssignal U2Y des ODER-Gatters U2, darunter das digitale Steuersignal RxGate (z.B. von extern erhalten), darunter das Ausgangssignal U1Y des Puffer-Verstärker U1, darunter die Gate-Spannung Vg, darunter das Ausgangssignal U4Y des UND-Gatters U4, und ganz unten die Versorgungsspannung Vd.

Die Zeitrichtung in Fig. 10 verläuft von links nach rechts, so dass zunächst zur Zeit t1 das digitale Steuersignal RxGate beispielsweise von logisch null auf logisch eins springt. Zur Zeit t2 (t2 > t1) ändern sich ebenfalls die Ausgangssignale U1Y, U4Y des Puffer-Verstärker U1 und des UND-Gatters U4 von logisch null nach logisch eins. Zur Zeit t3 (t3 > t2) ändert sich die Gate-Spannung Vg von 0 V auf die nominelle Gate-Spannung Vg,nom. Zur Zeit t4 (t4>t3) ändert sich die Versorgungsspannung Vd von einem Nullwert auf die nominelle Versorgungsspannung RxSupply.

Zur Zeit t5 (t5 > t4) wird von extern ein Empfangssignal RF-Pwr erhalten. Zur Zeit t6 (t6 > t5) wird eine Spannungsdifferenz ΔVg, die einen Schwellwert PRF,sw überschreitet festgestellt und ΔVg springt auf logisch eins. Zur Zeit t7 (t7 > t6) fällt das invertierte Ausgangssignal U3Q des Komparators U3 von logisch eins auf logisch null. Zur Zeit t8 (t8 > t7) fällt das Ausgangssignal des UND-Gatters U4Y von logisch eins auf logisch null. Zu einer Zeit t9 (t9 > t8) fällt das Ausgangssignal U2Y des ODER-Gatters U2 von logisch eins auf logisch null. Zur etwa gleichen Zeit kann auch die Drain-Spannung Vd auf 0V fallen. Zu einer Zeit t10 (t10 > t9) fällt das Ausgangssignal U1Y des Puffer-Verstärkers U1 von logisch eins auf logisch null. Zur Zeit t11 (t11 > t10) wird die Gate-Spannung Vg auf 0V gesetzt. Zu diesem Zeitpunkt ist der Schutz vor Übersteuerung vollständig aktiviert.

Zur Zeit t12 (t12>t11) ist das externe Empfangssignal zu Ende und fällt auf einen Wert logisch null. Zur Zeit t13 (t13 > t12) fällt die Spannungsdifferenz für die Steuerspannung ΔVg wieder auf einen Wert 0. Zur Zeit t14 (t14 > t13) wird das externe Rücksetzsignal RxReset eingegeben. Dies kann beispielsweise durch die Zustandsänderung der Spannungsdifferenz ΔVg zur Zeit t13 ausgelöst werden. Zur Zeit t15 (t15 > t14) wird ansprechend darauf das invertierte Ausgangssignal U3Q des Komparators wieder auf den Ausgangswert gesetzt und der Ausgang U2Y von dem ODER-Gatter U2 ebenfalls auf den Ausgangswert gesetzt. Zur Zeit t16 (t16 > t15) wird der Ausgang U1Y des Puffer-Verstärkers U1 als Resultat auf logisch eins gesetzt. Zur Zeit t17 (t17 > t16) wird das Ausgangssignal U4Y des UND-Gatters U4 auf logisch eins gesetzt. Zu etwa der gleichen Zeit wird die Gate-Spannung Vg wieder auf den Nominalwert Vg,nom gesetzt. Zur Zeit t18 (t18 > t17) wird der Versorgungsspannung Vd von 0V auf die nominale Versorgungsspannung RxSupply gesetzt. Damit ist der normale Empfangsbetriebszustand wieder hergestellt.

Zur Zeit t19 (t19>t18) wird das digitale Steuersignal RxGate von logisch eins auf logisch null gesetzt. Zur Zeit t20 (t20 > t19) wird das Ausgangssignal U1Y des Puffer-Verstärkers U1 von logisch eins auf logisch null gesetzt und das Ausgangssignal U4Y des UND-Gatters U4 von logisch eins auf logisch null gesetzt (muss aber nicht gleichzeitig erfolgen). Zur Zeit t21 (t21 > t20) wird die Drain-Spannung Vd wieder auf 0 V gesetzt. Zur Zeit t22 (t22 > t21) wird Gate-Spannung Vg auf 0 V gesetzt. Zu diesem Zeitpunkt ist der Schutz vor Übersteuerung durch Leckleistung im Sendebetrieb infolge einer begrenzten Isolation vollständig aktiviert.

Das Zeitablaufdiagramm der Fig. 10 entspricht somit den Kontroll- und Steuersignalen der Schaltungsanordnung gemäß Fig. 9, wobei die zeitlichen Abhängigkeiten sowie die Auslösevorgänge der jeweiligen Zustandsänderungen ersichtlich sind. Die zeitlichen Abstände zwischen den einzelnen Zeitpunkten ti (i=1...20) hängen von der Wahl der Bauelement (z.B. ihre Widerstandswerte oder Schaltzeiten) als auch von den Laufzeiten ab. Insbesondere wird durch entsprechende Dimensionierungen der Bauteile R5/C1 die Verzögerungszeit τd=t9-t7 so gewählt, dass die Gate-Spannung Vg des Verstärkers 110 erst dann zu 0 V erzwungen wird (zur Zeit t11), wenn die Drain-Spannung bereits 0 V beträgt (zur Zeit t9).

Ausgelöst wird der Schutzmechanismus zum Zeitpunkt t5 durch den Anstieg der am Eingang des T/R-Moduls eingespeisten HF-Leistung (RF-Pwr), die über einen definierten Schwellwert PRF,sw liegt und einen Anstieg des Gate-Stroms und damit der über den Widerstand R6 abfallende Spannungsdifferenz ΔVg bewirkt. Übersteigt diese den Schwellwert ΔVg,sw (zur Zeit t6), so wird U3Q zu "0" (zur Zeit t7) und in Folge dessen auch das Signal U4Y des AND-Gatters (zur Zeit t8) und schließlich die Drain-Spannung des Verstärkers 110 Vd (zur Zeit t9). So lange nicht mittels RxReset zurückgesetzt wird (zur Zeit t14), bleibt dieser Zustand erhalten, auch wenn vorzeitig die HF-Leistung am Modul-Eingang reduziert wird.

Nach Ablauf einer einstellbaren Verzögerungszeit τd wird der Ausgang U1Y des Puffer-Verstärkers U1 zu 0 V erzwungen (zur Zeit t10) und schließlich wird auch die Gate-Spannung niederohmig auf 0 V gesetzt (zur Zeit t11). Durch einen kurzen Puls des RxReset (zur Zeit t14) wird der Komparator U3 zurückgesetzt (zur Zeit t15) und dann nahezu zeitgleich, also ohne Verzögerung τd, der Puffer-Verstärker U1 aktiviert (zur Zeit t16) und, vorausgesetzt RxGate ist aktiv, die Gate-Spannung Vg auf die nominelle Gate-Spannung Vg,nom gebracht (zur Zeit t17). Durch die Zustandsänderung von U3Q̄ zu "1" (zur Zeit t15) wird, falls RxGate aktiv ist, auch das UND-Gatter U4 aktiviert (zur Zeit t17) und schließlich die Drain-Spannung Vd mit der Versorgungsspannung RxSupply versorgt (zur Zeit t18).

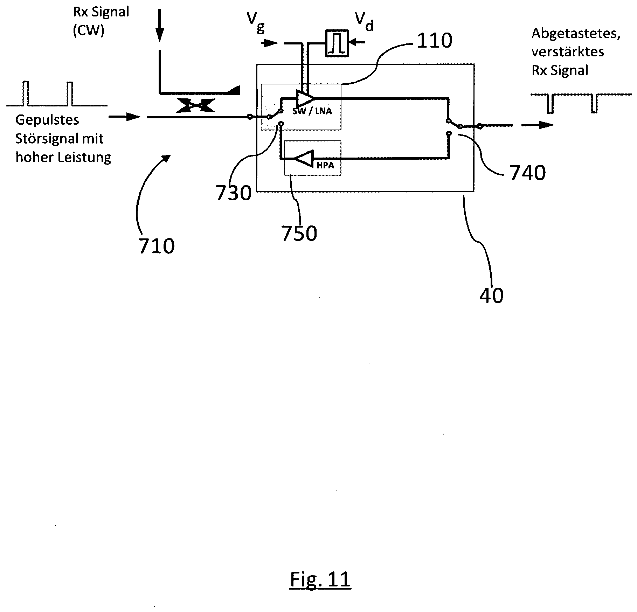

Fig. 11 zeigt das Prinzip eines Tests zum Nachweis der Wirksamkeit der Erfindung, wozu ein bestehendes Empfangsmodul 40 oder Frontend-Modul (FE-Modul) entsprechend zu Fig. 3 modifiziert wurde. Mit dem Test wird der Einfluss der Störleistung auf die HF-Eigenschaften des Empfangspfads ermittelt. In einer ersten Referenzmessung wurde der Einfluss einer HF-Übersteuerung im Rx-Betrieb auf die HF-Eigenschaften des FE-Moduls untersucht. Bei diesem Test wird am Antennen-Tor 710 ein dauerhaft anliegendes Nutzsignal (Rx-Signal) eingespeist. Das Störsignal wird in Form eines gepulsten Signals hoher Leistung ebenfalls am Antennen-Tor eingespeist. Bei diesem Test ist die Versorgungsspannung Vd des Verstärkers 110 ebenfalls zeitlich moduliert und mit dem Störsignal am Antenneneingang 710 synchronisiert, so dass zum Zeitpunkt der Übersteuerung die Versorgungsspannung Vd des Verstärkers 110 abgeschaltet ist. Die beiden Schalter 730, 740 sind während dieser Messung dauerhaft im Rx-Zustand (d.h. der Sendeverstärker 750 ist entkoppelt).

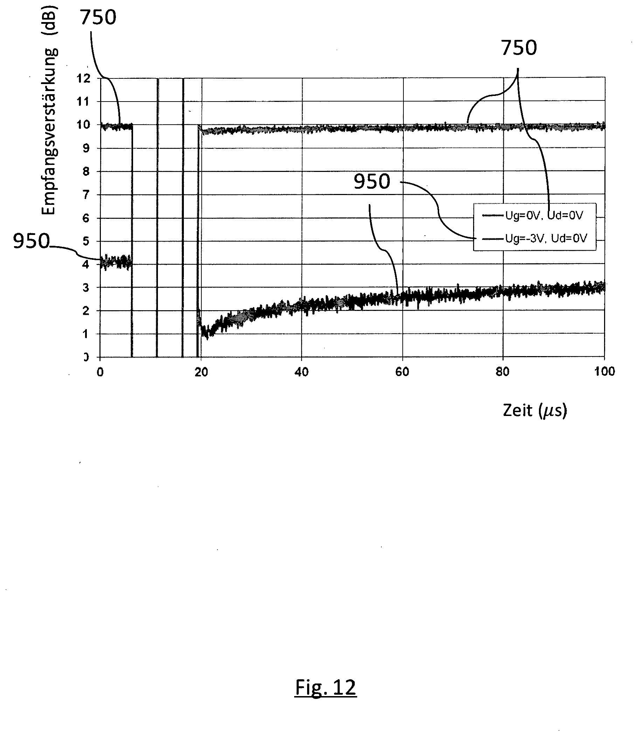

Fig. 12 zeigt das Ergebnis des Tests, wobei der zeitliche Verlauf der Empfangsverstärkung nach einem kurzen Störpuls mit hohem Leistungspegel (~1W), in konventionellem Betrieb (untere Kurve 950) und im Betrieb gemäß der Erfindung (obere Kurve 750) dargestellt ist.

Die erste Kurve 950 gibt den Einfluss der HF-Übersteuerung auf den zeitlichen Verlauf der Rx-Verstärkung (Empfangsverstärkung) eines HF-Frontends mit GaN HF-Komponenten wieder. Nachdem die Betriebsspannung am Verstärker 110 wieder anliegt (bei ca. 19 µs), stellt sich eine Rx-Verstärkung ein, die jedoch je nach Ausprägung der HF-Übersteurung deutlich von der nominellen Rx-Verstärkung (ca. 10 dB) abweicht. Anschließend erholt sich der Verstärker 110 und die Verstärkung nimmt wieder zu bis erneut ein Störpuls folgt. Bei einer großen Störleistung kann so die Verstärkung im Moment direkt nach Übersteuerung (bei ca. 20 µs) gegenüber der nominellen Rx-Verstärkung um bis zu 9 dB einbrechen.

Die zweite Kurve 750 in Fig. 12 ist das Ergebnis dieser Messung am selben Frontend, nachdem dieses gemäß der Erfindung wie in Fig. 3 dargestellt modifiziert und die Punkte 1 und 2 elektrisch verbunden wurden. Die Störleistung der HF-Übersteuerung ist in beiden Fällen identisch. In dieser Messung wird die Rx-Verstärkung durch die HF-Übersteuerung kaum beeinflusst. Die maximale Abweichung von der nominellen Rx-Verstärkung beträgt nur ca. 0,3 dB.

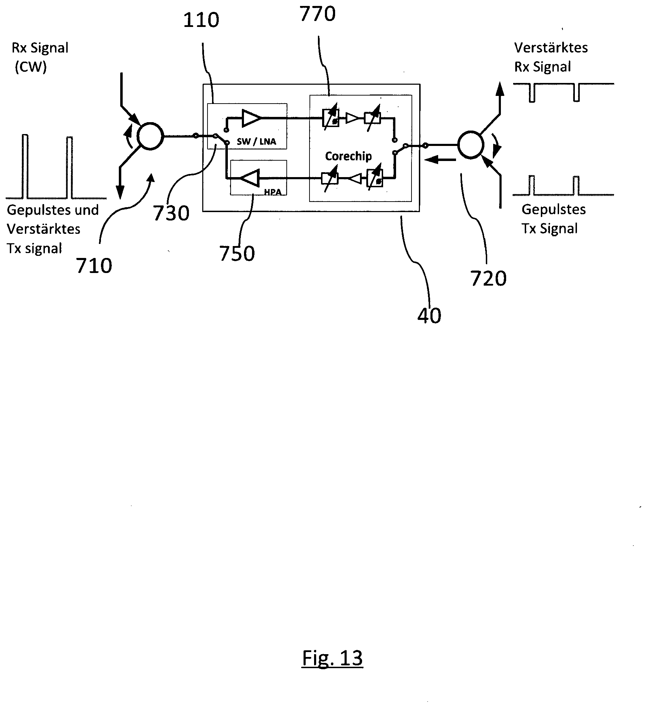

Fig. 13 veranschaulicht das Prinzip eines weiteren Tests, um die Wirksamkeit der Erfindung an einem T/R-Modul 40 (Sende-/Empfangsmodul) im Radarbetrieb nachzuweisen. Das untersuchte T/R-Modul entspricht dem Frontend-Modul 40, das für die oben beschriebenen Tests (in Fig. 11) verwendet wurde, ist jedoch im Unterschied dazu zusätzlich mit einem sogenannten Corechip (Kern-Chip; integrierter Schaltkreis mit der Fähigkeit sowohl das Sende- als auch das Empfangssignal in Betrag und Phase zu manipulieren sowie digitale Funktionalitäten beispielsweise zur Ansteuerung der Modulatoren bereitzustellen) 770 ausgerüstet. Für den Test wird, wie in Fig. 13 dargestellt, am Antennen-Tor 710 des T/R-Moduls 40 dauerhaft ein Rx-Nutzsignal eingespeist. Ein zweites HF-Signal (gepulstes Tx Signal) wird als Folge von kurzen Signalpulsen am Manifold-Tor 720 eingespeist und vom HPA 750 zum Sendesignal mit hoher Leistung (gepulstes und verstärktes Tx Signal) verstärkt. Aus der am Manifold-Tor 720 gemessenen HF-Leistung wird der zeitliche Verlauf der Rx-Verstärkung als Differenz zum am Antennen-Tor 720 eingespeisten Nutzsignal ermittelt. Auch dieser Test wurde zunächst am nicht modifizierten T/R-Modul 40 und anschließend am gemäß Fig. 3 modifizierten T/R-Modul 40 durchgeführt.

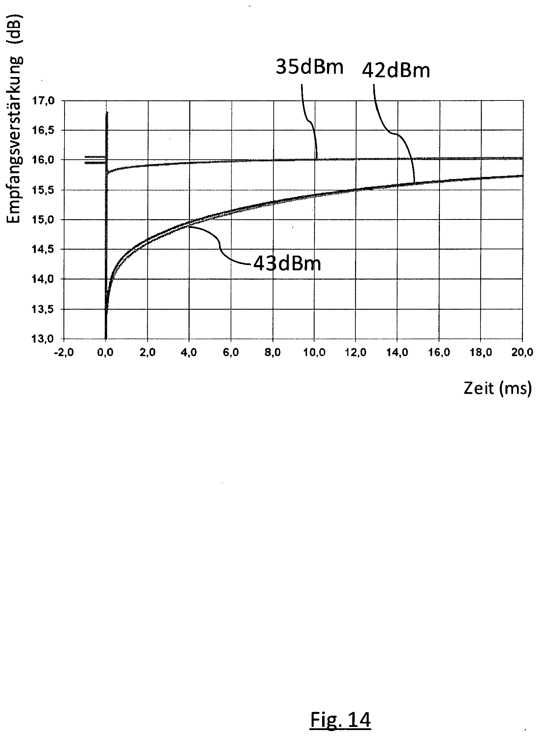

Fig. 14 zeigt am Beispiel des oben beschriebenen T/R-Moduls 40 ohne Modifikation gemäß der Erfindung (z.B. in einem typischen Pulsradarszenario) den zeitlichen Verlauf der Rx-Verstärkung für drei unterschiedliche Leistungspegel der Sendeleistung. Infolge einer begrenzten Isolation des T/R-Schalters 730 erreicht ein Teil der Sendeleistung den Eingang des Verstärkers 110. So ist eine deutliche Beeinflussung der Rx-Verstärkung durch die Sendeleistung erkennbar (auch im Radarbetrieb). Ab einer bestimmten Sendeleistung (z.B. > 35dBm) reicht die Pulswiederholdauer nicht aus, um die nominelle Rx-Verstärkung wieder zu erreichen. Diese Messung wurde für unterschiedliche Sendeleistungen wiederholt.

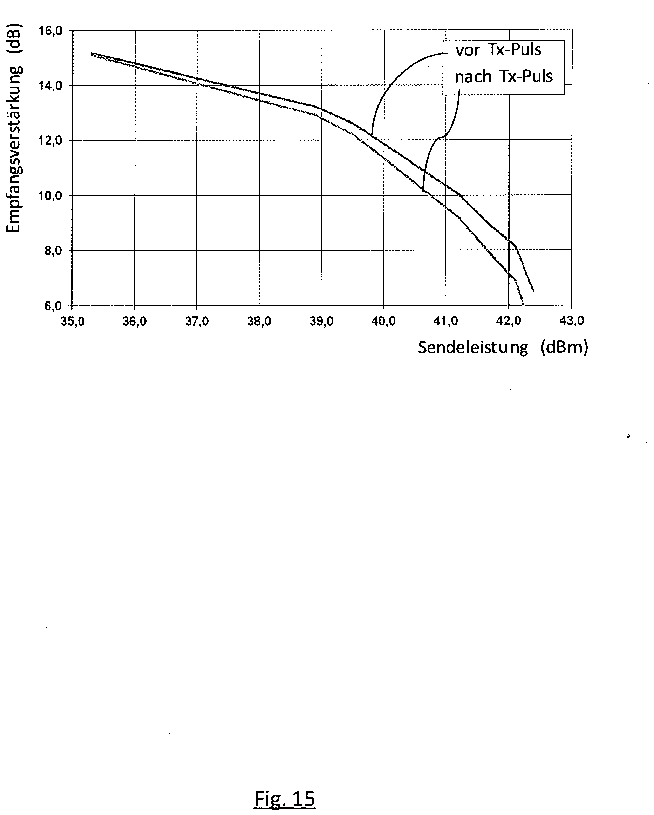

In Fig. 15 ist das Ergebnis dieser Messreihe dargestellt, wobei eine Empfangsverstärkung (zum Zeitpunkt direkt vor und direkt nach einem kurzen Sendepuls) in Abhängigkeit vom Leistungspegel des Sendesignals für ein typisches Pulsradarszenario dargestellt ist. Die obere Kurve entspricht dabei dem Wert der Rx-Verstärkung kurz vor Beginn des Sendepulses (Tx-Puls). Die untere Kurve entspricht dem Wert der Rx-Verstärkung kurz nach Ende des Sendepulses. Bei einer Sendeleistung von 42 dBm ist die Rx-Verstärkung ca. 8 dB geringer als die nominelle Rx-Verstärkung bzw. die Verstärkung, die sich bei einer Sendeleistung von 35 dBm ergibt. Eine so starke Abhängigkeit der RX-Verstärkung von der Sendeleistung ist für typische Radaranwendungen nicht akzeptabel.

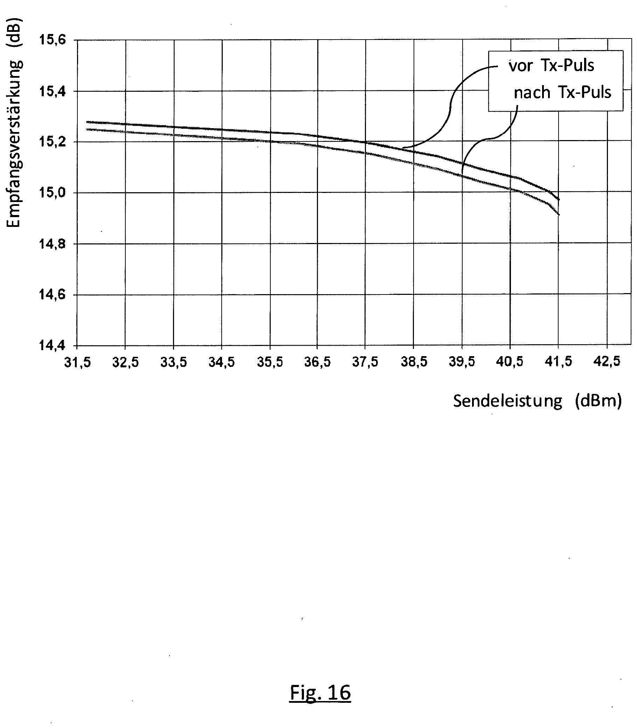

Die in Fig. 16 dargestellten Empfangsverstärkungen zeigen Ergebnisse derselben Messreihen (im typischen Pulsradarszenario) am gleichen T/R-Modul 40, jedoch mit dynamischer Ansteuerung der Gate-Spannung des Verstärkers 110 gemäß der Erfindung. Die damit erzielte Abhängigkeit der Rx-Verstärkung von der Sendeleistung ist marginal. Die maximale Abweichung gegenüber der nominellen Rx-Verstärkung beträgt bei einer Sendeleistung von 41,5 dBm nur ca. 0,35 dB.

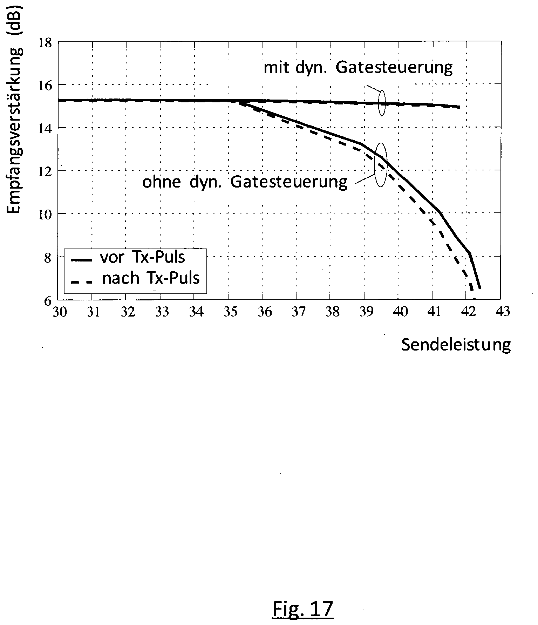

Fig. 17 zeigt die gemessene Empfangsverstärkung sowohl für das T/R-Modul 40 mit dynamischer Ansteuerung der Gate-Spannung des Verstärkers 110 (obere zwei Kurven mit nahezu konstanter Rx-Verstärkung) als auch für das ursprüngliche T/R-Modul ohne die dynamische Ansteuerung (untere zwei Kurven). Während das T/R-Modul 40 ohne dynamische Ansteuerung der Gate-Spannung Vg ab einer Sendeleistung von 35 dBm zunehmend in Form einer Abnahme der Rx-Verstärkung durch den Sendepuls beeinflusst wird, ist die Rx-Verstärkung beim T/R-Modul 40 mit dynamischer Ansteuerung der Gate-Spannung Vg gemäß der Erfindung in erster Näherung unabhängig von der Sendeleistung.

Mit den gezeigten Messreihen konnte folglich die Wirksamkeit des Verfahrens am Beispiel eines GaN basierten T/R Moduls nachgewiesen werden.

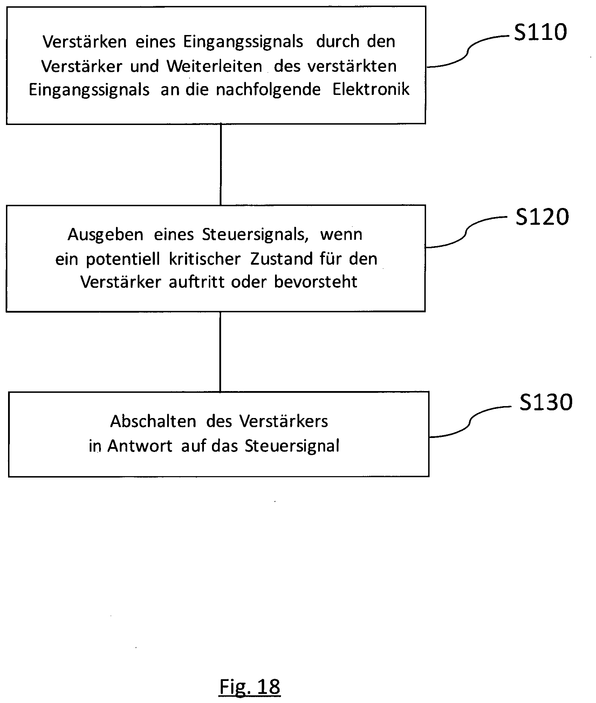

Fig. 18 zeigt ein Flussdiagramm für ein Verfahren zum Schutz eines Empfangsmoduls 40 mit einem Verstärker 110 oder zum Schutz einer nachfolgenden Schaltungselektronik 60. Das Verfahren umfasst die Schritte: Verstärken S110 eines Eingangssignals durch den Verstärker 110 und Weiterleiten des verstärkten Eingangssignals an die nachfolgende Schaltungselektronik 60, Ausgeben S120 eines Steuersignals 125, wenn ein potentiell kritischer Zustand für den Verstärker 110 oder für das Empfangsmodul 40 oder für die nachfolgende Schaltungselektronik 60 auftritt oder bevorsteht, und Abschalten S130 des Verstärkers 110 in Antwort auf das Steuersignal 125, wobei der abgeschaltete Verstärker 110 keine Verstärkung von Signalen am Eingang 112 durchführt, sondern die Signale am Eingang 112 durch eine teilweise oder vollständige Absorption oder Reflexion abschwächt.

Alle zuvor beschriebenen Funktionen der Vorrichtungen können als weitere optionale Verfahrensschritte in dem Verfahren umgesetzt sein.

Das Verfahren kann auch auf ein Steuergerät (beispielsweise einer Radaranlage) in Form von Software implementiert sein, die es ermöglicht, das Empfangsmodul zu steuern. Weitere Ausführungsbeispiele umfassen daher auch ein Speichermedium mit einem darauf gespeicherten Computerprogramm, welches ausgebildet ist, um eine Vorrichtung zu veranlassen, das zuvor beschriebene Verfahren auszuführen, wenn es auf einem Prozessor (Verarbeitungseinheit) läuft. Das Speichermedium kann ein maschinenlesbares Medium sein, das Mechanismus zum Speichern oder Übertragen von Daten in einer von einer Maschine (z.B. einem Computer) lesbaren Form beinhalten. Die Vorrichtung kann beispielsweise ein Steuermodul mit einem Prozessor sein, auf welchem das Computerprogramm läuft.

Bezugszeichenliste

| | |
|---|---|
| 40 | Empfangsmodul |
| 60 | nachfolgende Schaltungselektronik |
| 80 | Masse |
| 82 | Source-Netzwerk |
| 110 | Verstärker |
| 112 | Eingang des Verstärkers |
| 114 | Ausgang des Verstärkers |
| 115, 915 | Transistoren |
| 116, 916 | eingangsseitiges Anpassungsnetzwerk |
| 118, 918 | ausgangsseitiges Anpassungsnetzwerk |
| 120 | Detektionsmodul |
| 121, 122 | Auslöseschaltungen |
| 125 | Steuersignal |
| 130 | Abschalteinrichtung |
| 131, 132 | Modulatoren |
| 133 | Schalter |
| 930 | Eingangsfilter |
| 940 | Ausgangsfilter |
| Vd | Versorgungsspannung (Drain-Spannung) |
| Vpos, Vneg | positive/negative Versorgungsspannung |
| RxSupply | nominelle Versorgungsspannung |
| RxGate | digitales Steuersignal |
| Vg | Steuerspannung (Gate-Spannung) |
| Vg,nom | nominelle Steuerspannung |
| Vg,ctrl | erstes Steuersignal (für Gate-Spannung) |
| Vd,ctrl | zweites Steuersignal (für Drain-Spannung) |
| Rg, R'g | Vorwiderstände |
| C1, C2, ... | Kapazitäten |
| L1, L2 | Induktivitäten |
| T1, T2, ... | Transistoren |
| R1, R2,... | Widerstände |
| OP1, OP2, .. | Operationsverstärker |
| U1 | Puffer-Verstärker |
| U2 | ODER-Gatter |
| U3 | Komparator |
| U4 | UND-Gatter |

**Patentansprüche**

1. Schaltungsanordnung zum Schutz eines Empfangsmoduls (40) oder einer nachfolgenden Schaltungselektronik (60), mit folgenden Merkmalen:

ein Verstärker (110) mit einem Eingang (112) und einem Ausgang (114), der mit der nachfolgenden Schaltungselektronik (60) koppelbar ist, wobei der Verstärker (110) in dem Empfangsmodul (40) enthalten ist und einen Anschluss für eine Versorgungsspannung (Vd), einen Anschluss für eine Steuerspannung (Vg) und eine Masse (80) aufweist;
ein Steuermodul (120), das ausgebildet ist, um bei einem potentiell kritischen Zustand für den Verstärker (110) oder für das Empfangsmodul (40) oder für die nachfolgende Schaltungselektronik (60) ein Steuersignal (125) auszugeben;
eine Abschalteinrichtung (130), die ausgebildet ist, um den Verstärker (110) in Antwort auf das Steuersignal (125) abzuschalten, wobei der abgeschaltete Verstärker (110) keine Verstärkung von Signalen am Eingang (112) durchführt, sondern die Signale am Eingang (112) durch eine teilweise oder vollständige Absorption oder Reflexion abschwächt; und
wobei der Verstärker (110) einen Transistor (115) umfasst, der einen Strompfad zwischen dem Anschluss für die Versorgungsspannung (Vd) und der Masse (80) bereitstellt, wobei der Strompfad über ein Eingangssignal am Eingang (112) und über die Steuerspannung (Vg) steuerbar ist,
und wobei die Abschalteinrichtung (130) ausgebildet ist, um einen Stromfluss entlang des Strompfades durch den Transistor (115) beim Abschalten zu verhindern,
wobei
der potentiell kritische Zustand eine Übersteuerung des Verstärkers (110) oder ein Überschreiten eines Schwellenwertes für ein Signalpegel am Ausgang des Verstärkers (110) ist und das Steuersignal (125) ein erstes Steuersignal (Vg,ctrl) und ein zweites Steuersignal (Vd,ctrl) umfasst und die Abschalteinrichtung (130) einen ersten Modulator (131) und einen zweiten Modulator (132) aufweist, wobei der erste Modulator (131) ausgebildet ist, um ansprechend auf das erste Steuersignal (Vg,ctrl) die Steuerspannung (Vg) auf ein Nullpotential zu legen und der zweite Modulator (132) ausgebildet ist, um ansprechend auf das zweite Steuersignal (Vd,ctrl) die Versorgungsspannung (Vd) auf ein Nullpotential zu legen,

wobei die Steuerspannung (Vg) über einen variablen Vorwiderstand (Rg) steuerbar ist oder wobei ein variabler Vorwiderstand (Rg) zwischen der Steuerspannung (Vg) und einem Gate des Transistors gekoppelt ist,

wobei das Steuermodul (120) ausgebildet ist, um einen Widerstandswert des variablen Vorwiderstands (Rg) während des kritischen Zustandes zu verringern.

2. Schaltungsanordnung nach Anspruch 1, wobei die Abschalteinrichtung (130) einen Schalter (133; T2, T3) zur Überbrückung des Vorwiderstands (Rg) aufweist und das Steuermodul (120) ausgebildet ist, um den Schalter (133; T2, T3) bei Vorliegen des kritischen Zustands zu aktivieren und so den Vorwiderstand zu überbrücken.

3. Schaltungsanordnung nach einem der Ansprüche 1 bis 2, wobei das erste Steuersignal und das zweite Steuersignal (Vd,ctrl) durch eine Zustandsänderung einen zukünftigen kritischen Zustand anzeigen, und das Steuermodul (120) ausgebildet ist, um eine Zustandsänderung des zweiten Steuersignals (Vd,ctrl) zeitlich vor einer Zustandsänderung des ersten Steuersignals auszugeben, um die Versorgungsspannung (Vd) vor der Steuerspannung (Vg) auf das Nullpotential zu setzen.

4. Schaltungsanordnung nach Anspruch 3, wobei der zukünftige kritische Zustand ein bevorstehendes Senden eines Sendesignals (Tx-Puls) ist und das Steuermodul (120) weiter ausgebildet ist, um das erste Steuersignal (RxGate) vor einem Zeitpunkt (t2) des bevorstehenden Sendens des Sendesignals (Tx-Puls) auszugeben.

5. Schaltungsanordnung nach einem der Ansprüche 1 bis 4, wobei das Steuermodul (120) eine erste Auslöseschaltung (T2, OP1, OP2) und/oder eine zweite Auslöseschaltung (R6, U2, U3, U4) umfasst,

wobei die erste Auslöseschaltung (T2, OP1, OP2) ausgebildet ist, um beim Überschreiten eines Mindeststroms entlang des Strompfades durch den Transistor (115) das erste Steuersignal (Vg,ctrl) und/oder das zweite Steuersignal (Vd,ctrl) auszugeben, und/oder die zweite Auslöseschaltung (R6, U2, U3, U4) ausgebildet ist, um beim Überschreiten eines weiteren Mindeststroms durch den Anschluss für die Steuerspannung (Vg) des Transistors (115) das erste Steuersignal und/oder das zweite Steuersignal auszugeben.

6. Schaltungsanordnung nach Anspruch 5, wobei die erste Auslöseschaltung (T2, OP1, OP2) zumindest ein Bauelement (T2) umfasst, über das beim Überschreiten des Mindeststroms eine Mindestspannung (Vd-V'd) abfällt, um dadurch das erste Steuersignal (Vg,ctrl) und/oder das zweite Steuersignal (Vd,ctrl) auszulösen, und/oder die zweite Auslöseschaltung (R6, U2, U3, U4) zumindest ein Bauelement (R6) umfasst, über das beim Überschreiten des Mindeststroms eine Mindestspannung (ΔVg) abfällt, um dadurch das erste Steuersignal und/oder das zweite Steuersignal auszulösen.

7. Schaltungsanordnung nach Anspruch 5 oder Anspruch 6, wobei die zweite Auslöseschaltung (R6, U2, U3, U4) eine Verzögerungsschaltung (U2, R5, C1) aufweist, die ausgebildet ist, um das erste Steuersignal zeitlich verzögert nach einem Signal (U3$\overline{Q}$), das ein Überschreiten des Mindestspannungsabfall (ΔVg) anzeigt, auszugeben, um so den Anschluss für die Versorgungsspannung (Vd) vor dem Anschluss für die Steuerspannung (Vg) auf ein Nullpotential zu setzen.

8. Schaltungsanordnung nach Anspruch 7, die ausgebildet ist, um ein Rücksetzsignal (RxReset) zu empfangen und das Steuermodul (120) ausgebildet ist, um das Signal (U3$\overline{Q}$), das ein Überschreiten des Mindestspannungsabfall (ΔVg) anzeigt, bis zum Empfang des Rücksetzsignals (RxReset) auszugeben.

9. Schaltungsanordnung nach einem der Ansprüche 5 bis 8, wobei die erste Auslöseschaltung (T2, OP1, OP2) ausgebildet ist, um bei einem Unterschreiten eines Minimalstroms entlang des Strompfades das erste Steuersignal (Vg,ctrl) und/oder das zweite Steuersignal (Vd,ctrl) aufzuheben, und/oder

die zweite Auslöseschaltung (R6, U2, U3, U4) ausgebildet ist, um bei einem Unterschreiten eines weiteren Minimalstroms durch den Anschluss für die Steuerspannung (Vg) des Transistors (115) das erste Steuersignal und/oder das zweite Steuersignal aufzuheben,

wobei eine Aufhebung des ersten Steuersignals (Vg,ctrl) und/oder des zweiten Steuersignals (Vd,ctrl) eine Rückkehr in einen normalen Betriebsmodus bewirkt und der Minimalstrom kleiner ist als der Mindeststrom.

10. Sende-/Empfangsmodul, insbesondere einer Radaranlage, mit einer Schaltungsanordnung nach einem der vorhergehenden Ansprüche.

11. Verfahren zum Schutz eines Empfangsmoduls (40) mit einem Verstärker (110) oder zum Schutz einer nachfolgenden Schaltungselektronik (60), mit folgenden Schritten:

Verstärken (Sno) eines Eingangssignals durch den Verstärker (110) und Weiterleiten des verstärkten Eingangssignals an die nachfolgende Schaltungselektronik (60), wobei der Verstärker (110) in dem Empfangsmodul enthalten ist und einen Anschluss für eine Versorgungsspannung (Vd), einen Anschluss für eine Steuerspannung (Vg) und eine Masse (80) aufweist;

Ausgeben (S120) eines Steuersignals (125), wenn ein potentiell kritischer Zustand für den Verstärker (110) oder für das Empfangsmodul (40) oder für die nachfolgende Schaltungselektronik (60) auftritt oder bevorsteht; und

Abschalten (S130) des Verstärkers (110) in Antwort auf das Steuersignal (125), wobei der abgeschaltete Verstärker (110) keine Verstärkung von Signalen am Eingang (112) durchführt, sondern die Signale am Eingang (112) durch eine teilweise oder vollständige Absorption oder Reflexion abschwächt und wobei der Verstärker (110) einen Transistor (115) umfasst, der einen Strompfad zwischen dem Anschluss für die Versorgungsspannung (Vd) und Masse (80) bereitstellt, und das Abschalten einen Stromfluss entlang des Strompfades durch den Transistor (115) verhindert,

wobei

der potentiell kritische Zustand eine Übersteuerung des Verstärkers (110) oder ein Überschreiten eines Schwellenwertes für ein Signalpegel am Ausgang des Verstärkers (110) und das Steuersignal (125) ein erstes Steuersignal (Vg,ctrl) und ein zweites Steuersignal (Vd,ctrl) umfasst und ansprechend auf das erste Steuersignal (Vg,ctrl) die Steuerspannung (Vg) auf ein Nullpotential gelegt wird und ansprechend auf das zweite Steuersignal (Vd,ctrl) die Versorgungsspannung (Vd) auf ein Nullpotential gelegt wird,

wobei die Steuerspannung (Vg) über einen variablen Vorwiderstand (Rg) steuerbar ist oder wobei ein variabler Vorwiderstand (Rg) zwischen der Steuerspannung (Vg) und einem Gate des Transistors gekoppelt ist,

und ein Widerstandswert des variablen Vorwiderstands (Rg) während des kritischen Zustandes verringert wird.

12. Computerprogrammprodukt mit darauf gespeichertem Software-Code, der ausgebildet ist, um das Verfahren nach Anspruch 11 auszuführen, wenn der Software-Code durch eine Verarbeitungseinheit ausgeführt wird.

**Claims**

1. Circuit arrangement for protecting a receiving module (40) or subsequent circuit electronics (60), comprising the following features:

an amplifier (no) with an input (112) and an output (114), which is couplable to the subsequent circuit electronics (60), wherein the amplifier (no) is contained in the receiving module (40) and has a connection for a supply voltage (Vd), a connection for a control voltage (Vg), and a ground (80);

a control module (120) configured to output a control signal (125) in a potentially critical state for the amplifier (110) or for the receiving module (40) or for the subsequent circuit electronics (60);

a shutdown device (130) configured to shut down the amplifier (no) in response to the control signal (125), wherein the shut-down amplifier (no) does not amplify signals at the input (112) but attenuates the signals at the input (112) through partial or complete absorption or reflection; and

wherein the amplifier (no) comprises a transistor (115) that provides a current path between the connection for the supply voltage (Vd) and the ground (80), wherein the current path is controllable via an input signal at the input (112) and via the control voltage (Vg),

and wherein the shutdown device (130) is configured to prevent current flow along the current path through the transistor (115) when shutting down,

wherein

the potentially critical state is an overdrive of the amplifier (110) or an exceeding of a threshold for a signal level at the output of the amplifier (no), and the control signal (125) comprises a first control signal (Vg,ctrl) and a second control signal (Vd,ctrl), and the shutdown device (130) comprises a first modulator (131) and a second modulator (132), wherein the first modulator (131) is configured to set the control voltage (Vg) to a zero potential in response to the first control signal (Vg,ctrl), and the second modulator (132) is configured to set the supply voltage (Vd) to a zero potential in response to the second control signal (Vd,ctrl),

wherein the control voltage (Vg) is controllable via a variable series resistor (Rg) or wherein a variable series resistor (Rg) is coupled between the control voltage (Vg) and a gate of the transistor,

wherein the control module (120) is configured to reduce a resistance value of the variable series resistor (Rg) during the critical state.

2. Circuit arrangement according to claim 1, wherein the shutdown device (130) comprises a switch (133; T2, T3) for bypassing the series resistor (Rg), and the control module (120) is configured to activate the switch (133; T2, T3) in the presence of the critical condition, thereby bypassing the series resistor.

3. Circuit arrangement according to one of claims 1 to 2, wherein the first control signal and the second control signal (Vd,ctrl) indicate an imminent critical condition by a state change, and the control module (120) is configured to output a state change of the second control signal (Vd,ctrl) temporally before a state change of the first control signal, in order to set the supply voltage (Vd) to zero potential before the control voltage (Vg).

4. Circuit arrangement according to claim 3, wherein the imminent critical condition is an upcoming transmission of a transmission signal (Tx-pulse), and the control module (120) is further configured to output the first control signal (RxGate) before a time point (t2) of the upcoming transmission of the transmission signal (Tx-pulse).

5. Circuit arrangement according to one of claims 1 to 4, wherein the control module (120) comprises a first trigger circuit (T2, OP1, OP2) and/or a second trigger circuit (R6, U2, U3, U4),

   wherein the first trigger circuit (T2, OP1, OP2) is configured to output the first control signal (Vg,ctrl) and/or the second control signal (Vd,ctrl) when a minimal current along the current path through the transistor (115) is exceeded, and/or
   the second trigger circuit (R6, U2, U3, U4) is configured to output the first control signal and/or the second control signal when another minimal current through the terminal for the control voltage (Vg) of the transistor (115) is exceeded.

6. Circuit arrangement according to claim 5, wherein the first trigger circuit (T2, OP1, OP2) comprises at least one component (T2) over which a minimum voltage (Vd-V'd) drops when the minimal current is exceeded, thereby triggering the first control signal (Vg,ctrl) and/or the second control signal (Vd,ctrl), and/or
   the second trigger circuit (R6, U2, U3, U4) comprises at least one component (R6) over which a minimum voltage (∆Vg) drops when the minimal current is exceeded, thereby triggering the first control signal and/or the second control signal.

7. Circuit arrangement according to claim 5 or claim 6, wherein the second trigger circuit (R6, U2, U3, U4) includes a delay circuit (U2, R5, C1) configured to output the first control signal delayed in time after a signal (U3 $\overline{Q}$) indicating that the minimum voltage drop (∆Vg) has been exceeded, in order to set the terminal for the supply voltage (Vd) to zero potential before the terminal for the control voltage (Vg).

8. Circuit arrangement according to claim 7, configured to receive a reset signal (RxReset), and the control module (120) is configured to output the signal (U3$\overline{Q}$) indicating that the minimum voltage drop (∆Vg) has been exceeded until the reset signal (RxReset) is received.

9. Circuit arrangement according to one of claims 5 to 8, wherein the first trigger circuit (T2, OP1, OP2) is configured to cancel the first control signal (Vg,ctrl) and/or the second control signal (Vd,ctrl) when a minimum current along the current path is undershot, and/or

   the second trigger circuit (R6, U2, U3, U4) is configured to cancel the first control signal and/or the second control signal when another minimum current through the terminal for the control voltage (Vg) of the transistor (115) is undershot,
   wherein a cancellation of the first control signal (Vg,ctrl) and/or the second control signal (Vd,ctrl) results in a return to a normal operating mode, and the minimum current is less than the minimal current.

10. Transmission/reception module, particularly of a radar system, with a circuit arrangement according to one of the preceding claims.

11. Method for protecting a receiving module (40) with an amplifier (no) or for protecting subsequent circuit electronics (60), comprising the following steps:

   amplifying (S110) an input signal by the amplifier (no) and forwarding the amplified input signal to the subsequent circuit electronics (60), wherein the amplifier (no) is contained in the reception module and has a terminal for a supply voltage (Vd), a terminal for a control voltage (Vg), and a ground (80);
   issuing (S120) a control signal (125) when a potentially critical condition occurs or is imminent for the amplifier (110), the receiving module (40), or the subsequent circuit electronics (60); and
   shutting down (S130) the amplifier (110) in response to the control signal (125), wherein the shut-down amplifier (110) does not amplify signals at the input (112) but attenuates the signals at the input (112) through partial or complete absorption or reflection, and wherein the amplifier (110) comprises a transistor (115) that provides a current path between the terminal for the supply voltage (Vd) and ground (80), and the shutdown prevents a current flow along the current path through the transistor (115),
wherein

the potentially critical condition is an overdrive of the amplifier (110) or an exceedance of a threshold value for a signal level at the output of the amplifier (110), and the control signal (125) includes a first control signal (Vg,ctrl) and a second control signal (Vd,ctrl), and in response to the first control signal (Vg,ctrl), the control voltage (Vg) is set to zero potential, and in response to the second control signal (Vd,ctrl), the supply voltage (Vd) is set to zero potential,

wherein the control voltage (Vg) is controllable via a variable series resistor (Rg) or wherein a variable series resistor (Rg) is coupled between the control voltage (Vg) and a gate of the transistor,

and a resistance value of the variable series resistor (Rg) is reduced during the critical condition.

12. Computer program product with software code stored thereon, configured to perform the method according to claim 11 when the software code is executed by a processing unit.

**Revendications**

1. Agencement de circuit pour la protection d'un module de réception (40) ou d'une électronique de circuit ultérieure (60), comprenant les caractéristiques suivantes :

un amplificateur (110) avec une entrée (112) et une sortie (114), couplable à l'électronique de circuit ultérieure (60), l'amplificateur (110) étant contenu dans le module de réception (40) et ayant une borne pour une tension d'alimentation (Vd), une borne pour une tension de commande (Vg) et une masse (80) ;
un module de commande (120) configuré pour émettre un signal de commande (125) dans un état potentiellement critique pour l'amplificateur (110), pour le module de réception (40) ou pour l'électronique de circuit ultérieure (60) ;
un dispositif d'arrêt (130) configuré pour arrêter l'amplificateur (110) en réponse au signal de commande (125), l'amplificateur arrêté (110) n'amplifiant pas les signaux à l'entrée (112) mais atténuant les signaux à l'entrée (112) par absorption ou réflexion partielle ou complète ; et
où l'amplificateur (110) comprend un transistor (115) qui fournit un chemin de courant entre la borne pour la tension d'alimentation (Vd) et la masse (80), le chemin de courant étant contrôlable via un signal d'entrée à l'entrée (112) et via la tension de commande (Vg),
et où le dispositif d'arrêt (130) est configuré pour empêcher le flux de courant le long du chemin de courant à travers le transistor (115) lors de l'arrêt,
où

l'état potentiellement critique est une surmodulation de l'amplificateur (110) ou un dépassement d'une valeur seuil pour un niveau de signal à la sortie de l'amplificateur (110), et le signal de commande (125) comprend un premier signal de commande (Vg,ctrl) et un deuxième signal de commande (Vd,ctrl), et le dispositif d'arrêt (130) comprend un premier modulateur (131) et un deuxième modulateur (132), où le premier modulateur (131) est configuré pour régler la tension de commande (Vg) à un potentiel nul en réponse au premier signal de commande (Vg,ctrl) et le deuxième modulateur (132) est configuré pour régler la tension d'alimentation (Vd) à un potentiel nul en réponse au deuxième signal de commande (Vd,ctrl),
où la tension de commande (Vg) est contrôlable via une résistance série variable (Rg) ou où une résistance série variable (Rg) est couplée entre la tension de commande (Vg) et une grille du transistor,
où le module de commande (120) est configuré pour réduire une valeur de résistance de la résistance série variable (Rg) pendant l'état critique.

2. Agencement de circuit selon la revendication 1, dans lequel le dispositif d'arrêt (130) comprend un interrupteur (133 ; T2, T3) pour court-circuiter la résistance série variable (Rg), et le module de commande (120) est configuré pour activer l'interrupteur (133 ; T2, T3) en présence de l'état critique, court-circuitant ainsi la résistance série variable.

3. Agencement de circuit selon l'une des revendications 1 à 2, dans lequel le premier signal de commande et le deuxième signal de commande (Vd,ctrl) indiquent un état critique futur par un changement d'état, et le module de commande (120) est configuré pour émettre un changement d'état du deuxième signal de commande (Vd,ctrl) avant un changement d'état du premier signal de commande, afin de régler la tension d'alimentation (Vd) à un potentiel nul avant la tension de commande (Vg).

4. Agencement de circuit selon la revendication 3, dans lequel l'état critique futur est une émission imminente d'un signal d'émission (Tx-impulsion), et le module de commande (120) est en outre configuré pour émettre le premier signal de commande (RxGate) avant un instant (t2) de l'émission imminente du signal d'émission (Tx-impulsion).

5. Agencement de circuit selon l'une des revendications 1 à 4, dans lequel le module de commande (120) comprend un premier circuit de déclenchement (T2, OP1, OP2) et/ou un deuxième circuit de déclenchement (R6, U2, U3, U4),

où le premier circuit de déclenchement (T2, OP1, OP2) est configuré pour émettre le premier signal de commande (Vg,ctrl) et/ou le deuxième signal de commande (Vd,ctrl) lorsqu'un courant minimal le long du chemin de courant à travers le transistor (115) est dépassé, et/ou le deuxième circuit de déclenchement (R6, U2, U3, U4) est configuré pour émettre le premier signal de commande et/ou le deuxième signal de commande lorsqu'un autre courant minimal à travers la borne pour la tension de commande (Vg) du transistor (115) est dépassé.

6. Agencement de circuit selon la revendication 5, dans lequel le premier circuit de déclenchement (T2, OP1, OP2) comprend au moins un composant (T2) sur lequel une tension minimale (Vd-V'd) chute lorsque le courant minimal est dépassé, déclenchant ainsi le premier signal de commande (Vg,ctrl) et/ou le deuxième signal de commande (Vd,ctrl), et/ou le deuxième circuit de déclenchement (R6, U2, U3, U4) comprend au moins un composant (R6) sur lequel une tension minimale ($\Delta$Vg) chute lorsque le courant minimal est dépassé, déclenchant ainsi le premier signal de commande et/ou le deuxième signal de commande.

7. Agencement de circuit selon la revendication 5 ou 6, dans lequel le deuxième circuit de déclenchement (R6, U2, U3, U4) comprend un circuit à retard (U2, R5, C1) configuré pour émettre le premier signal de commande de manière retardée dans le temps après un signal (U3 $\overline{Q}$) indiquant que la chute de tension minimale ($\Delta$Vg) a été dépassée, afin de régler la borne pour la tension d'alimentation (Vd) à un potentiel nul avant la borne pour la tension de commande (Vg).

8. Agencement de circuit selon la revendication 7, configuré pour recevoir un signal de réinitialisation (RxReset), et le module de commande (120) est configuré pour émettre le signal (U3 $\overline{Q}$) indiquant que la chute de tension minimale ($\Delta$Vg) a été dépassée jusqu'à ce que le signal de réinitialisation (RxReset) soit reçu.

9. Agencement de circuit selon l'une des revendications 5 à 8, dans lequel le premier circuit de déclenchement (T2, OP1, OP2) est configuré pour annuler, en cas de sous-dépassement d'un courant minimum le long du chemin de courant, le premier signal de commande (Vg,ctrl) et/ou le deuxième signal de commande (Vd,ctrl) , et/ou

le deuxième circuit de déclenchement (R6, U2, U3, U4) est configuré pour annuler , en cas de sous-dépassement d'un autre courant minimum à travers la borne pour la tension de commande (Vg) du transistor (115), le premier signal de commande et/ou le deuxième signal de commande, où une annulation du premier signal de commande (Vg,ctrl) et/ou du deuxième signal de commande (Vd,ctrl) provoque un retour à un mode de fonctionnement normal, et où le courant minimum est inférieur au courant minimal.

10. Module d'émission/réception, en particulier d'un système radar, avec un agencement de circuit selon l'une des revendications précédentes.

11. Procédé de protection d'un module de réception (40) avec un amplificateur (110) ou de protection d'une électronique de circuit ultérieure (60), comprenant les étapes suivantes :

amplification (S110) d'un signal d'entrée par l'amplificateur (110) et transmission du signal d'entrée amplifié à l'électronique de circuit ultérieure (60), l'amplificateur (110) étant contenu dans le module de réception et ayant une borne pour une tension d'alimentation (Vd), une borne pour une tension de commande (Vg) et une masse (80) ; émission (S120) d'un signal de commande (125) lorsqu'un état potentiellement critique survient ou est imminent pour l'amplificateur (110), le module de réception (40) ou l'électronique de circuit ultérieure (60) ; et arrêt (S130) de l'amplificateur (110) en réponse au signal de commande (125), l'amplificateur arrêté (110) n'amplifiant pas les signaux à l'entrée (112) mais atténuant les signaux à l'entrée (112) par absorption ou réflexion partielle ou complète, et l'amplificateur (110) comprenant un transistor (115) qui fournit un chemin de courant entre la borne pour la tension d'alimentation (Vd) et la masse (80), l'arrêt empêchant un flux de courant le long du chemin de courant à travers le transistor (115), où l'état potentiellement critique est une surmodulation de l'amplificateur (110) ou un dépassement d'une valeur seuil pour un niveau de signal à la sortie de l'amplificateur (110), et le signal de commande (125) comprend un premier signal de commande (Vg,ctrl) et un deuxième signal de commande (Vd,ctrl), et en réponse au premier signal de commande (Vg,ctrl), la tension de commande (Vg) est mise à un potentiel nul, et en réponse au deuxième signal de commande (Vd,ctrl), la tension d'alimentation (Vd) est mise à un potentiel nul,
où la tension de commande (Vg) est contrôlable via une résistance série variable (Rg) ou une résistance série variable (Rg) est couplée entre la tension de commande (Vg) et une grille du transistor,
et une valeur de résistance de la résistance série variable (Rg) est réduite pendant l'état critique.

12. Produit de programme informatique avec un code logiciel stocké dessus, configuré pour exécuter le procédé selon la revendication 11 lorsque le code logiciel est exécuté par une unité de traitement.

<u>Fig. 1</u>

Fig. 2

Fig. 3

Fig. 4

26

Fig. 5

Fig. 6

Fig. 7

EP 3 211 791 B1

Fig. 8

Fig. 9

EP 3 211 791 B1

**Rx Reset**
von ext.

**RF-Pwr>P$_{RF,sw}$**
von ext.

$\Delta V_{g,sw}$

$\Delta V_g$
wenn RF-Pwr>P$_{RF,sw}$
0

t5   t12
t13

**U3$\overline{Q}$**
wenn RF-Pwr>P$_{RF,sw}$
wenn RxReset=low; dann U3LE=U3Q

t6   t14

$\leftarrow \tau_d \rightarrow$

**U2Y**
=>U1LE

**RxGate**
von ext.

**U1Y**
wenn U2y=low; dann "low";
sonst RxGate

t9

0V

**V$_g$**
V$_{g,nom}$

t2   t10   t16   t20
t3   t11   t22

**U4Y**
= (U3$\overline{Q}$ & RxGate)

t1   t7   t15   t19

**RxSupply**

**V$_d$**
0V

t2   t8   t17   t19
t4   t9   t18   t21

Fig. 10

Rx Signal
(CW)

$V_g$        $V_d$

110

Abgetastetes,
verstärktes
Rx Signal

Gepulstes
Störsignal mit
hoher Leistung

SW / LNA

HPA

730

750

740

710

40

Fig. 11

Fig. 12

**110**     **770**

Rx Signal
(CW)

Verstärktes
Rx Signal

**SW / LNA**

**Corechip**

**HPA**

Gepulstes und
Verstärktes
Tx signal

Gepulstes
Tx Signal

**730**

**710**

**750**

**720**

**40**

<u>Fig. 13</u>

Fig. 14

Fig. 15

Fig. 16

Fig. 17

Verstärken eines Eingangssignals durch den
Verstärker und Weiterleiten des verstärkten
Eingangssignals an die nachfolgende Elektronik

S110

Ausgeben eines Steuersignals, wenn
ein potentiell kritischer Zustand für den
Verstärker auftritt oder bevorsteht

S120

Abschalten des Verstärkers
in Antwort auf das Steuersignal

S130

**Fig. 18**

$V_g$    $V_d$

$R_g$

930

940

RF in ○ —[Eingangs-MN]—

[Ausgangs-MN] ○ RF out

916

915

918

80

Fig. 19

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2541763 A
- US 2011275330 A
- US 20080218271 A
- JP 2013162297 B
- JP 2002237728 A